# EUROPEAN PATENT APPLICATION

(11) **EP 4 761 539 A1**
(43) Date of publication of application: **17.06.2026**
(21) Application number: 25212036.5
(22) Date of filing: 29.10.2025
(51) Int. Cl.: H10K 59/121, H10H 29/30, H10H 29/41, H10H 29/854, H10H 29/80, H10K 59/80

(54) **DISPLAY DEVICE**

(30) Priority: 11.12.2024 KR 20240183688
(71) Applicant: LG Display Co., Ltd., Seoul, 07336 (KR)
(72) Inventor: HEO, JoonYoung, 10845 Paju-si, Gyeonggi-do (KR); KIM, ChulHo, 10845 Paju-si, Gyeonggi-do (KR)
(74) Representative: Viering, Jentschura & Partner mbB Patent- und Rechtsanwälte

(57) **Abstract**

A display device may include a first display area (DA1), a second display area (DA2) including a plurality of first transmission areas (TA1), a first light emitting device (ED1) located in the first display area (DA1), a second light emitting device (ED2) located in the second display area (DA2) and disposed between the plurality of first transmission areas (TA1), a first passivation layer (650) disposed to surround a side surface of the first light emitting device (ED1), and a second passivation layer (700) disposed to surround a side surface of the second light emitting device (ED2).

## Description

### TECHNICAL FIELD

The present disclosure relates to a display device.

### BACKGROUND

As technology advances, a display device may provide image capturing functions and various sensing functions in addition to image display functions. Accordingly, a display device can be equipped with electronic devices such as a camera and a detection sensor (which may also be referred to as a light receiving device or sensor).

Since an electronic device for image capturing or sensing may receive light from the front of a display device, the electronic device is typically installed in a location capable of receiving the light. Therefore, a camera (e.g., a camera lens) and a detection sensor can be are installed to be exposed to the front of a display device. In such scenarios, a bezel of the display device may become larger or a camera or detection sensor may be installed in a notch or physical hole formed in a display area of the display panel, which causes a reduction in the display area.

As such, in a display device is equipped with electronic devices such as cameras and detection sensors which receive light from the front, the bezel on the front of the display device may become larger or restrictions may occur in the front design of the display device.

A display device can be applied to various electronic devices such as TVs, mobile phones, laptops, and tablets. A display device may include an organic light-emitting display (OLED as a self-luminous display device, and/or a liquid crystal display (LCD) including a separate light source.

Recently, a display device including a light-emitting diode (LED) is attracting attention as a next-generation display device. Since the light-emitting diode is made of inorganic materials rather than organic materials, a display device including a light-emitting diodes has a faster lighting speed, excellent light-emitting efficiency, and can display high-luminance images compared to a liquid crystal display device or an organic light emitting display device.

### SUMMARY

According to an aspect of the present disclosure, a display device according to claim 1 is provided. Further implementations are described in the dependent claims.

A display device according to implementations of the present disclosure may include a first display area, a second display area including a plurality of first transmission areas, a first light emitting device located in the first display area, a second light emitting device located in the second display area and disposed between the plurality of first transmission areas, a first passivation layer disposed to surround a side surface of the first light emitting device, and a second passivation layer disposed to surround a side surface of the second light emitting device.

A display device according to implementations of the present disclosure may include a substrate including a first display area and a second display area, the second display area including a plurality of first transmission areas, a first light emitting device located in the first display area, a second light emitting device located in the second display area and disposed between the plurality of first transmission areas, and an insulating layer stack disposed between the substrate and the first light emitting device, and between the substrate and the second light emitting device. The substrate may have a plurality of first holes overlapping with the plurality of first transmission areas, and the insulating layer stack may have a plurality of second holes overlapping with the plurality of first transmission areas.

According to the implementations of the present disclosure, it is possible to provide a display device having a light transmission structure which allows an electronic device located below a display panel to normally receive light without exposing the electronic device receiving light to the front.

According to the implementations of the present disclosure, it is possible to provide a display device having a light transmission structure suitable for inorganic-based light emitting devices.

According to the implementations of the present disclosure, it is possible to provide a display device having a light transmission structure capable of increasing the transmittance of a transmission area.

According to the implementations of the present disclosure, it is possible to provide a display device capable of improving the luminance in a display area including a light transmission area.

According to the implementations of the present disclosure, it is possible to provide a display device capable of achieving high brightness even with low power by using inorganic-based light emitting device.

The effects of the present disclosure are not limited to the effects described above, and other effects not described will be clearly understood by those skilled in the art from the description below.

### BRIEF DESCRIPTION OF THE DRAWINGS

The present disclosure will be more fully understood from the detailed description and accompanying drawings provided below, which are provided for illustration only and are not intended to limit the present disclosure.
FIG. 1 a plan view of an example of a display device according to implementations of the present disclosure.
FIG. 2 illustrates a system configuration diagram of an example of a display device according to implementations of the present disclosure.
FIG. 3 illustrates a display panel of an example of a display device according to implementations of the present disclosure.
FIG. 4 illustrates an example of a light emitting device in a display panel according to implementations of the present disclosure.
FIG. 5 illustrates a planar structure of an example of first to third display areas of a display panel according to implementations of the present disclosure.
FIG. 6 is a cross-sectional view of an example of a first display area of a display panel according to implementations of the present disclosure.
FIG. 7 is a cross-sectional view of an example of a second display area of a display panel according to implementations of the present disclosure.
FIG. 8 is a cross-sectional view of an example of a third display area of a display panel according to implementations of the present disclosure.
FIG. 9 illustrates a planar structure of an example of first to third display areas of a display panel according to implementations of the present disclosure.
FIG. 10 is a cross-sectional view of an example of a first display area of a display panel according to implementations of the present disclosure.
FIG. 11 is a cross-sectional view of an example of a second display area of a display panel according to implementations of the present disclosure.
FIG. 12 is a cross-sectional view of an example of a third display area of a display panel according to implementations of the present disclosure.
FIGS. 13 to 15 illustrate an example of a manufacturing process for a second display area of a display panel according to implementations of the present disclosure.

### DETAILED DESCRIPTION

Implementations of the present disclosure can provide a display device having a light transmission structure which allows an electronic device located below a display panel to normally receive light without exposing the electronic device receiving light to the front.

Implementations of the present disclosure can provide a display device having a light transmission structure suitable for inorganic-based light emitting devices.

Implementations of the present disclosure can provide a display device having a light transmission structure capable of increasing the transmittance of a transmission area.

Implementations of the present disclosure can provide a display device capable of improving the luminance in a display area including a light transmission area.

Hereinafter, implementations of the disclosure are described in detail with reference to the accompanying drawings. In assigning reference numerals to components of each drawing, the same components may be assigned the same numerals even when they are shown on different drawings. When determined to make the subject matter of the disclosure unclear, the detailed of the known art or functions may be skipped. As used herein, when a component "includes," "has," or "is composed of' another component, the component may add other components unless the component "only" includes, has, or is composed of' the other component. As used herein, the singular forms "a", "an" and "the" are intended to include the plural forms as well, unless the context clearly indicates otherwise.

Such denotations as "first," "second," "A," "B," "(a)," and "(b)," may be used in describing the components of the disclosure. These denotations are provided merely to distinguish a component from another, and the essence, order, or number of the components are not limited by the denotations.

In describing the positional relationship between components, when two or more components are described as "connected", "coupled" or "linked", the two or more components may be directly "connected", "coupled" or "linked" ", or another component may intervene. Here, the other component may be included in one or more of the two or more components that are "connected", "coupled" or "linked" to each other.

When such terms as, e.g., "after", "next to", "after", and "before", are used to describe the temporal flow relationship related to components, operation methods, and fabricating methods, it may include a non-continuous relationship unless the term "immediately" or "directly" is used.

When a component is designated with a value or its corresponding information (e.g., level), the value or the corresponding information may be interpreted as including a tolerance that may arise due to various factors (e.g., process factors, internal or external impacts, or noise).

Hereinafter, various implementations of the disclosure are described in detail with reference to the accompanying drawings.

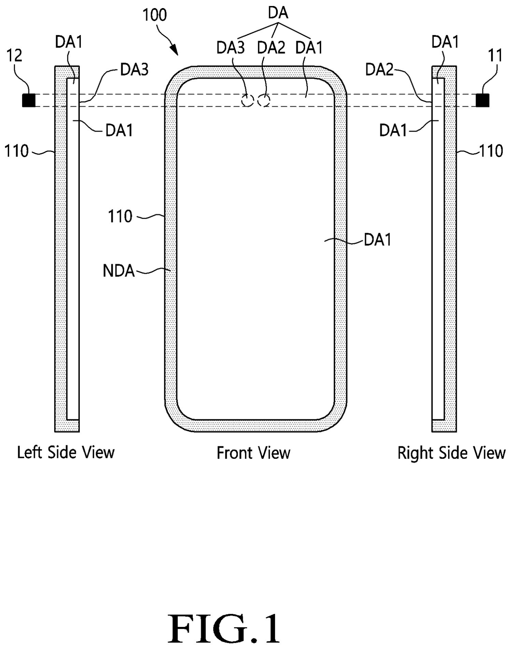

FIG. 1 is a plan view of an example of a display device 100 according to implementations of the present disclosure.

Referring to FIG. 1, a display device 100 according to implementations of the present disclosure may include a display panel 110 for displaying an image and one or more electronic devices 11 and 12.

The display panel 110 may include a display area DA where an image is displayed and a non-display area NDA where an image is not displayed.

There may be disposed a plurality of sub-pixels and a plurality of signal lines for driving the plurality of sub-pixels in the display area DA.

The non-display area NDA may be an area outside the display area DA. Various signal lines may be disposed in the non-display area NDA, and various driving circuits may be connected thereto. The non-display area NDA may be bent so that it is not visible from the front or may be obscured by a case (not shown). The non-display area NDA may be also referred as a bezel or a bezel area.

In a display device 100 according to implementations of the present disclosure, one or more electronic devices 11 and 12 may be provided and installed separately from the display panel 110, and may be an electronic component located at the lower part of the display panel 110 (i.e., opposite the viewing surface).

One or more electronic devices 11 and 12 may be devices which receive light passing through the display panel 110 and perform a predetermined operation using the received light. For example, the one or more electronic devices 11 and 12 may include one or more of a photographing device such as a camera (i.e., image sensor), a detection sensor such as a proximity sensor, and an illuminance sensor. Here, for example, the detection sensor may be an infrared sensor.

The light required for the operation of one or more electronic devices 11 and 12 may enter the front (i.e., viewing side) of the display panel 110, pass through the display panel 110, and may be delivered to one or more electronic devices 11 and 12 located below the display panel 110 (i.e., opposite the viewing surface). For example, light required for the operation of one or more electronic devices 11 and 12 and passing through the display panel 110 may include visible light, infrared light or ultraviolet light.

The display area DA of the display panel 110 according to the implementations of the present disclosure may include a first display area DA1 corresponding to a normal area, and a second display area DA2 distinct from the first display area DA1.

The first display area DA1 may be a normal area or a general area in which a plurality of sub-pixels for image display are arranged and light-transmission is not possible, and the second display area DA2 may be an area in which a plurality of sub-pixels for image display are arranged and light transmission is possible. The first display area DA1 may be located on the periphery of the second display area DA2. For example, the first display area DA1 may be located to surround the second display area DA2.

The second display area DA2 may overlap with a first electronic device 11. The first electronic device 11 may perform a first operation determined by using a first light of a first wavelength band transmitting through the second display area DA2.

As an example, the first wavelength band may be a visible light wavelength band, the first light may be visible light, and the first operation may mean a photographing operation (or image sensing operation). That is, the first electronic device 11 may be a camera that performs a photographing operation by using visible light.

As another example, the first wavelength band may be an infrared wavelength band or an ultraviolet wavelength band, the first light may be infrared light, and the first operation may mean a detection function. That is, the first electronic device 11 may be a detection sensor such as a proximity sensor and an illuminance sensor that performs a detection operation of detecting the surroundings by using infrared light.

The display area DA of the display panel 110 according to the implementations of the present disclosure may include a third display area DA3 that is distinct from the first display area DA1 and the second display area DA2.

The third display area DA3 may be an area in which a plurality of sub-pixels for image display are arranged and light transmission is possible. The first display area DA1 may be located on the periphery of the third display area DA3. For example, the first display area DA1 may be located to surround the third display area DA3. The third display area DA3 may be connected to the second display area DA2 or separated from the second display area DA2. That is, the first display area DA1 may or may not exist between the second display area DA2 and the third display area DA3.

The third display area DA3 may overlap with a second electronic device 12. The second electronic device 12 may perform a second operation determined by using the second light of the second wavelength band transmitting through the third display area DA3.

As an example, the second wavelength band may be an infrared wavelength band or an ultraviolet wavelength band, the second light may be infrared light, and the second operation may mean a detection function. That is, the second electronic device 12 may be a detection sensor such as a proximity sensor and an illuminance sensor that performs a detection operation of detecting the surroundings by using infrared light.

As another example, the second wavelength band may be a visible light wavelength band, the second light may be visible light, and the second operation may mean a photographing operation (or image sensing operation). That is, the second electronic device 12 may be a camera that performs a photographing operation by using visible light.

The second display area DA2 and the third display area DA3 may be optical areas having light transmission characteristics. The second display area DA2 may be referred to as a first optical area, and the third display area DA3 may be referred to as a second optical area. Since the second display area DA2 and the third display area DA3 are areas that allow light transmission, each of the second display area DA2 and the third display area DA3 may have a structure that allows light transmission.

Since the second display area DA2 and the third display area DA3 are areas that can also display images, each of the second display area DA2 and the third display area DA3 may include a plurality of sub-pixels for displaying images.

Since the second display area DA2 and/or the third display area DA3 are areas capable of transmitting light and displaying images, when viewed from the front (viewing surface) of the display panel 110, the first electronic device 11 overlapping with the second display area DA2 and/or the second electronic device 12 overlapping with the third display area DA3 may be configured so as not be visible to the user.

For example, the first electronic device 11 may be a camera that receives light (e.g., visible light) in the visible light wavelength band, and the second electronic device 12 may be a detection sensor such as a proximity sensor or an illuminance sensor. For example, the detection sensor may be an infrared sensor that detects light (e.g., infrared light) in the infrared wavelength band. Alternatively, the first electronic device 11 may be a detection sensor, and the second electronic device 12 may be a camera.

Hereinafter, for convenience of explanation, there is exemplified a case in which the first electronic device 11 is a camera and the second electronic device 12 is an infrared-based detection sensor. Here, the camera may be a camera lens or an image sensor.

In the case that the first electronic device 11 is a camera, the camera may be located behind (i.e., below) the display panel 110, but may be a front camera for photographing images in the front direction of the display panel 110. Accordingly, the user may view a viewing surface of the display panel 110 and take pictures or self-photographs using a camera which is not visible to the viewing surface.

The second display area DA2 and the third display area DA3 according to some implementations can have transmittance above a specific level for effective operation, and the first display area DA1 may not have light transmittance at all or may have low transmittance below a specific level.

For example, the optical area of the second display area DA2 and/or the third display area DA3 may be different from the first display area DA1 in at least one aspect of the resolution, the sub-pixel arrangement structure, the number of sub-pixels per unit area (or the number of pixels per unit area), the electrode structure, the electrode material, the signal line structure, the signal line material, the electrode arrangement structure, or the signal line arrangement structure.

For example, the second display area DA2 and the third display area DA3 may differ from each other in at least one aspect of resolution, sub-pixel arrangement structure, number of sub-pixels per unit area (or number of pixels per unit area), electrode structure, electrode material, signal line structure, signal line material, electrode arrangement structure, or signal line arrangement structure.

The transmittance of the second display area DA2 and/or the third display area DA3 can be higher than the transmittance of the first display area DA1.

For example, to increase the transmittance of the second display area DA2 and/or the third display area DA3, the display panel 110 according to the implementations of the present disclosure may be designed with differential pixel density in the different areas.

According to the differential pixel density, according to some implementations, the display panel 110 may be designed so that the number of pixels per unit area (or the number of sub-pixels per unit area) of the second display area DA2 and/or the third display area DA3 is less than the number of pixels per unit area (or the number of sub-pixels per unit area) of the first display area DA1. In such implementations, the resolution of the second display area DA2 and/or the third display area DA3 can be lower than the resolution of the first display area DA1. As such, differential pixel density may also be referred to as differential resolution.

The number of pixels per unit area (or the number of sub-pixels per unit area) may indicate a pixel density. For example, the unit of the number of pixels per unit area may be PPI (pixels per inch), which indicates the number of pixels in one inch.

In order to increase the transmittance of the second display area DA2 and/or the third display area DA3, the display panel 110 according to the implementations of the present disclosure may be designed in a differential pixel size.

For example, according to the differential pixel size, the display panel 110 may be designed so that the number of sub-pixels per unit area of the second display area DA2 and/or the third display area DA3 is the same as or similar to the number of sub-pixels per unit area of the first display area DA1. In some implementations, the size of each sub-pixel SP (e.g., the size of the emission area) disposed in the second display area DA2 and/or the third display area DA3 is smaller than the size of each sub-pixel SP (i.e., the size of the emission area) disposed in the first display area DA1.

The second display area DA2 and the third display area DA3 corresponding to the optical area may have the same or substantially the same transmittance. In this case, the number of pixels per unit area of the second display area DA2 may be the same as the number of pixels per unit area of the third display area DA3. The resolution of the second display area DA2 may be the same as the resolution of the third display area DA3.

The second display area DA2 and the third display area DA3 corresponding to the optical area may have different transmittances. For example, the transmittance of the second display area DA2 may be higher than the transmittance of the third display area DA3. In this case, the number of pixels per unit area of the second display area DA2 may be less than the number of pixels per unit area of the third display area DA3. The resolution of the second display area DA2 may be lower than the resolution of the third display area DA3. For example, a camera using visible light may require more light than a detection sensor (e.g., infrared sensor) using infrared light. For example, if the first electronic device 11 overlapping with the second display area DA2 is a camera and the second electronic device 12 overlapping with the third display area DA3 is a detection sensor (e.g., infrared sensor), the transmittance of the second display area DA2 may be higher than the transmittance of the third display area DA3.

For example, the second display area DA2 may have various shapes such as circular, oval, square, hexagon, or octagon. The third display area DA3 may have various shapes, such as circular, oval, square, hexagon, or octagon. The second display area DA2 and the third display area DA3 may have the same shape or different shapes.

If the second display area DA2 and the third display area DA3 are in contact, the entire optical area including the second display area DA2 and the third display area DA3 may have various shapes such as a circle, an oval, a square, a hexagon, or an octagon. Hereinafter, for convenience of explanation, it will be exemplified a case in which each of the second display area DA2 and the third display area DA3 has a circular shape.

In the display device 100 according to some implementations of the present disclosure, if the first electronic device 11, which is not exposed to the outside and is hidden at the bottom of the display panel 110, is a camera, then the display device 100 may be referred as a display device to which UDC (Under Display Camera) technology is applied.

Accordingly, in the display device 100 according to implementations of the present disclosure, there may not be a need to form a notch or camera hole for camera exposure in the display panel 110, so that there is no reduction in area of the display area DA. Accordingly, the size of the bezel area may be reduced, design restrictions may be eased, and the degree of freedom in design may be increased.

In the display device 100 according to implementations of the present disclosure, in scenarios where the one or more electronic devices 11 and 12 are hidden behind the display panel 110, the one or more electronic devices 11 and 12 can still operate by receiving light normally (e.g., similar to being exposed to the outside) and can normally perform a designated function thereof.

In addition, in the display device 100 according to implementations of the present disclosure, even though the first electronic device 11 and/or the second electronic device 12 are positioned to overlap with the second display area DA2 and/or the third display area DA3, the display device 100 can still normally display an image in the second display area DA2 and/or the third display area DA3.

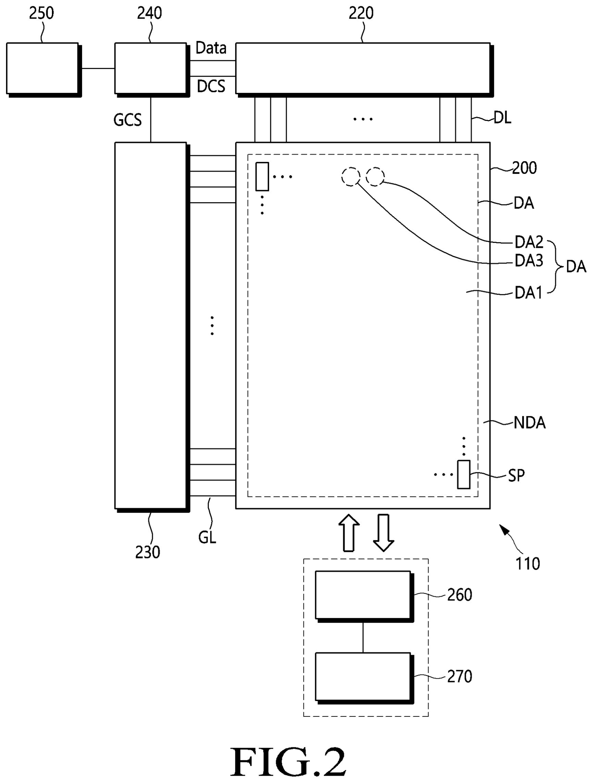

FIG. 2 illustrates an example of a system configuration diagram of a display device 100 according to implementations of the present disclosure.

Referring to FIG. 2, the display device 100 may include a display panel 110 and a display driving circuit as components for displaying an image. The display driving circuit may be a circuit for driving the display panel 110, and may include a data driving circuit 220, a gate driving circuit 230 and a display controller 240.

The display panel 110 may include a display area DA for displaying an image and a non-display area NDA where an image is not displayed. The non-display area NDA may be an area outside the display area DA, and may also be referred to as a bezel area. All or part of the non-display area NDA may be an area visible from the front of the display device 100, or may be an area which is bent and not visible from the front of the display device 100.

The display panel 110 may include a substrate 200 and a plurality of sub-pixels SP disposed on the substrate 200. Additionally, the display panel 110 may further include various types of signal lines to drive the plurality of sub-pixels SP.

The display device 100 according to implementations of the present disclosure may be a self-luminous display device in which the display panel 110 emits light on its own. In the display device 100 according to implementations of the present disclosure, each of the plurality of sub-pixels SP may include a light emitting device. For example, the display device 100 according to implementations of the present disclosure may be an organic light emitting display device in which a light emitting device is implemented as an organic light emitting diode (OLED. For another example, the display device 100 according to implementations of the present disclosure may be an inorganic light emitting display device in which the light emitting device is implemented as an inorganic-based light emitting diode. For another example, the display device 100 according to implementations of the present disclosure may be a quantum dot display device in which a light emitting device is implemented with quantum dots, which are self-luminous semiconductor crystals.

The structure of each of the plurality of sub-pixels SP may vary depending on the type of the display device 100. For example, if the display device 100 is a self-luminous display device in which sub-pixels SP emit light by themselves, each sub-pixel SP may include a light emitting device emitting light by itself, one or more transistors, and one or more capacitors.

For example, various types of signal lines may include a plurality of data lines DL transmitting data signals (also referred to as data voltages or image signals) and a plurality of gate lines GL transmitting gate signals (also referred to as scan signals).

The plurality of data lines DL and the plurality of gate lines GL may cross each other. Each of the plurality of data lines DL may be arranged to extend in a first direction. Each of the plurality of gate lines GL may be arranged to extend in a second direction. Here, the first direction may be a column direction and the second direction may be a row direction. Alternatively, the first direction may be a row direction and the second direction may be a column direction. Hereinafter, for convenience of explanation, it will be described an example in which each of a plurality of data lines DL is arranged in the column direction, and each of a plurality of gate lines GL is arranged in the row direction.

The data driving circuit 220 is a circuit for driving a plurality of data lines DL, and may output data signals to the plurality of data lines DL. The gate driving circuit 230 is a circuit for driving a plurality of gate lines GL, and may output gate signals to the plurality of gate lines GL.

The display controller 240 may be a device for controlling the data driving circuit 220 and the gate driving circuit 230, and may control the driving timing for the plurality of data lines DL and the driving timing of the plurality of gate lines GL.

The display controller 240 may supply a data driving control signal DCS to the data driving circuit 220 to control the data driving circuit 220, and may supply a gate driving control signal GCS to the gate driving circuit 230 to control the gate driving circuit 230.

The display controller 240 may receive input image data from a host system 250 and supply image data to the data driving circuit 220 based on the input image data.

The data driving circuit 220 may receive image data in digital form from the display controller 240 and convert the received image data into analog data signals to output to a plurality of data ines DL.

The gate driving circuit 230 may receive a first gate voltage corresponding to the turn-on level voltage and a second gate voltage corresponding to the turn-off level voltage along with various gate driving control signals GCS, and may generate gate signals and supply the generated gate signals to the plurality of gate lines GL.

For example, the data driving circuit 220 may be connected to the display panel 110 using a tape automated bonding (TAB) method, or may be connected to the bonding pad of the display panel 110 using a chip-on-glass (COG) or chip-on-panel (COP) method, or may be implemented using a chip-on-film (COF) method and connected to the display panel 110.

The gate driving circuit 230 may be connected to the display panel 110 using a tape automated bonding (TAB) method, or may be connected to the bonding pad of the display panel 110 using a chip-on-glass (COG) or chip-on-panel (COP) method, or may be implemented using a chip-on-film (COF) method and connected to the display panel 110. Alternatively, the gate driving circuit 230 may be a gate-in-panel (GIP) type and may be formed in the non-display area NDA of the display panel 110. The gate driving circuit 230 may be disposed on or connected to the substrate. That is, if the gate driving circuit 230 is a GIP type, the gate driving circuit 230 may be disposed in the non-display area NDA of the substrate. The gate driving circuit 230 may be connected to the substrate if the gate driving circuit 230 is a chip-on-glass (COG) type, a chip-on-film (COF) type, etc.

Meanwhile, at least one of the data driving circuit 220 and the gate driving circuit 230 may be disposed in the display area DA of the display panel 110. For example, at least one of the data driving circuit 220 and the gate driving circuit 230 may be arranged not to overlap the sub-pixels SP, or may be arranged to partially or entirely overlap with the sub-pixels SP.

The data driving circuit 220 may be connected to one side (e.g., the upper or lower side) of the display panel 110. Depending on the driving method, panel design method, etc., the data driving circuit 220 may be connected to both sides (e.g., upper and lower sides) of the display panel 110, or may be connected to two or more of the four sides of the display panel 110.

The gate driving circuit 230 may be connected to one side (e.g., left or right side) of the display panel 110. Depending on the driving method, panel design method, etc., the gate driving circuit 230 may be connected to both sides (e.g., left and right side) of the display panel 110, or may be connected to two or more of the four sides of the display panel 110.

The display controller 240 may be implemented as a separate component from the data driving circuit 220, or may be integrated with the data driving circuit 220 and implemented as an integrated circuit.

The display controller 240 may be a timing controller used in typical display technology, or may be a control device capable of further performing other control functions including a timing controller, or may be a control device different from the timing controller, or may be a control device other than a timing controller, or may be a circuit within the control device. The display controller 240 may be implemented with various circuits or electronic components, such as an integrated circuit (IC), a field programmable gate array (FPGA), an application specific integrated circuit (ASIC), or Processor.

The display controller 240 may be mounted on a printed circuit board, a flexible printed circuit, etc., and may be electrically connected to the data driving circuit 220 and the gate driving circuit 230 through a printed circuit board, a flexible printed circuit.

The display controller 240 may transmit and receive signals with the data driving circuit 220 according to one or more predetermined interfaces. For example, the interface may include a low voltage differential signaling (LVDS) interface, an embedded clock point-point interface (EPI) interface, or a serial peripheral interface (SPI).

In order to provide not only an image display function but also a touch sensing function, the display device 100 according to implementations of the present disclosure may include a touch sensor and a touch sensing circuit for detecting an occurrenace of a touch by a touch object such as a finger or pen or for detecting a touch position by sensing the touch sensor.

The touch sensing circuit may include a touch driving circuit 260 for driving and sensing a touch sensor to generate and output touch sensing data, and a touch controller 270 for detecting the occurrence of a touch or detecting the touch position using touch sensing data.

The touch sensor may include a plurality of touch electrodes. The touch sensor may further include a plurality of touch lines to electrically connect a plurality of touch electrodes and the touch driving circuit 260.

The touch sensor may exist outside the display panel 110 in the form of a touch panel or may exist inside the display panel 110. If the touch sensor exists outside the display panel 110 in the form of a touch panel, the touch sensor may be referred to as an external type. If the touch sensor is an external type, the touch panel and the display panel 110 may be manufactured separately and combined during the assembly process. The external touch panel may include a touch panel substrate and a plurality of touch electrodes on the touch panel substrate.

If the touch sensor exists inside the display panel 110, the touch sensor may be formed on the substrate 200 along with signal lines and electrodes related to display driving during the manufacturing process of the display panel 110.

The touch driving circuit 260 may supply a touch driving signal to at least one of the plurality of touch electrodes and generate touch sensing data by sensing at least one of the plurality of touch electrodes.

The touch sensing circuit may perform touch sensing using a self-capacitance sensing method or a mutual-capacitance sensing method.

If the touch sensing circuit performs touch sensing using a self-capacitance sensing method, the touch sensing circuit may perform touch sensing based on the capacitance between each touch electrode and a touch object (e.g., finger, pen, etc.). According to the self-capacitance sensing method, each of the plurality of touch electrodes may serve as a driving touch electrode and a sensing touch electrode. The touch driving circuit 260 may drive all or part of the plurality of touch electrodes and sense all or part of the plurality of touch electrodes.

If the touch sensing circuit performs touch sensing using the mutual-capacitance sensing method, the touch sensing circuit may perform touch sensing based on the capacitance between touch electrodes. According to the mutual-capacitance sensing method, the plurality of touch electrodes may be divided into driving touch electrodes and sensing touch electrodes. The touch driving circuit 260 may drive driving touch electrodes and sense sensing touch electrodes.

The touch driving circuit 260 and the touch controller 270 included in the touch sensing circuit may be implemented as separate devices or as one device. Additionally, the touch driving circuit 260 and the data driving circuit 220 may be implemented as separate devices or as one device.

The display device 100 may further include a power supply circuit which supplies various types of power to the display driving circuit and/or the touch sensing circuit.

The display device 100 according to implementations of the present disclosure may be a mobile terminal such as a smart phone or tablet, or a monitor or television of various sizes, but is not limited thereto, and may be a display of various types and sizes capable of displaying information or images.

As described above, in the display panel 110, the display area DA may include the second display area DA2 and the third display area DA3 in addition to a first display area DA1. In the following, for convenience of explanation, it will be described an example in which the display area DA includes a first display area DA1, a second display area DA2, and a third display area DA3.

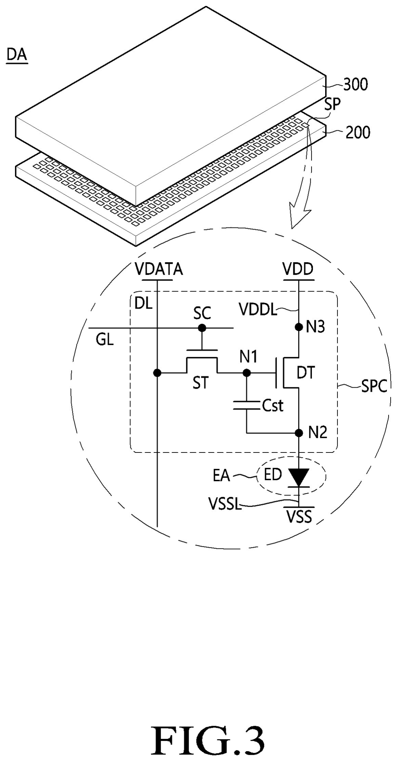

FIG. 3 illustrates an example of a display panel according to implementations of the present disclosure.

Referring to FIG. 3, a plurality of sub-pixels SP may be disposed in the display area DA of the display panel 110. For example, as discussed for FIG. 1, above, a plurality of sub-pixels SP may be disposed in the first display area DA1, the second display area DA2, and the third display area DA3 included in the display area DA.

Each of the plurality of sub-pixels SP may include a light emitting device ED and a sub-pixel circuit SPC configured to drive the light emitting device ED.

Referring to FIG. 3, the sub-pixel circuit SPC may include a driving transistor DT for driving the light emitting device ED, a scan transistor ST for transferring the data voltage Vdata to the driving transistor DT, and a storage capacitor Cst for maintaining a constant voltage during one frame.

The driving transistor DT may include a first node N1 to which a data voltage may be applied, a second node N2 electrically connected to a light emitting device ED, and a third node N3 to which a driving voltage (also called high voltage power) VDD is applied from a driving voltage line (also called high voltage power line) VDDL. In the driving transistor DT, the first node N1 may be a gate node, the second node N2 may be a source node or a drain node, and the third node N3 may be a drain node or a source node. Hereinafter, for convenience of explanation, it will be exemplified a case in which, in the driving transistor DT, the first node N1 is a gate node, the second node N2 is a source node, and the third node N3 is a drain node. For example, the third node N3 may be connected to the driving voltage line VDDL.

The light emitting device ED can emit light according to the driving of the sub-pixel circuit SPC. A light-emitting area EA can be formed by light emitted from the light emitting device ED. For example, the light emitting device ED may be an organic light emitting diode (OLED), an inorganic-based light emitting diode (LED), or a quantum dot light emitting device. For example, if the light emitting device ED is an organic light emitting diode (OLED), an emission layer EL in the light emitting device ED may include an organic emission layer EL containing an organic material. For example, if the light emitting device ED is an inorganic-based light emitting diode (LED), the light emitting device ED may be a micro light emitting diode (micro LED). The light emitting device ED may include a first electrode and a second electrode. For example, the first electrode may be an anode electrode, and the second electrode may be a cathode electrode. As another example, the first electrode may be a cathode electrode and the second electrode may be an anode electrode. For example, the first electrode or second electrode may be connected to a base voltage line (also called low voltage power line) VSSL to which a base voltage (also called low voltage power) VSS is applied.

The scan transistor ST may be turned on and off by a scan signal SC, which is a gate signal applied through a gate line GL, and may be electrically connected between the first node N1 of the driving transistor DT and a data line DL.

The storage capacitor Cst may be electrically connected between the first node N1 and the second node N2 of the driving transistor DT.

The sub-pixel circuit SPC may have a 2T (Transistor) 1C (Capacitor) structure including two transistors (e.g., DT and ST) and one capacitor Cst as illustrated in FIG. 3, and may further include one or more transistors or one or more capacitors, depending on the case. For example, the sub-pixel circuit SPC may have a 7T1C structure including seven transistors and one capacitor Cst.

The storage capacitor Cst may be an external capacitor intentionally designed outside the driving transistor DT, rather than a parasitic capacitor (e.g., gate-source capacitor Cgs, gate-drain capacitor Cgd) that may exist between the first node N1 and the second node N2 of the driving transistor DT. Each of the driving transistor DT and the scan transistor ST may be an n-type transistor or a p-type transistor.

Since the circuit elements (particularly, the light emitting device ED implemented as an organic light-emitting diode including an organic material) in each sub-pixel SP are vulnerable to external moisture or oxygen, an encapsulation layer may be disposed on the display panel 110 to prevent external moisture or oxygen from penetrating into the circuit elements (particularly, the light emitting device ED. The encapsulation layer ENCAP may be disposed in a form that covers the light emitting devices ED.

The display panel 110 according to the implementations of the present disclosure may further include a touch sensor layer 300 for touch sensing. The touch sensor layer 300 may include a plurality of touch electrodes.

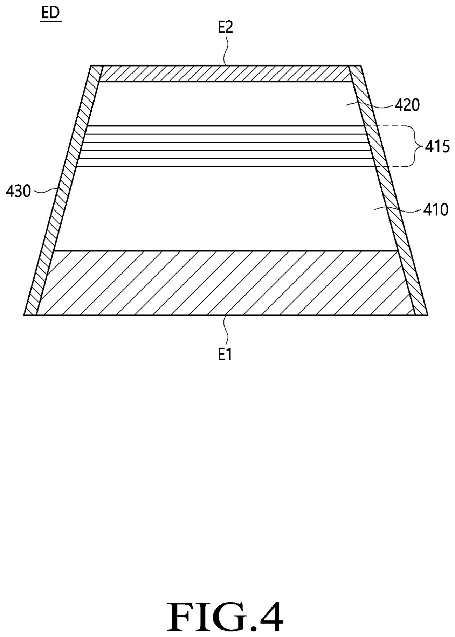

FIG. 4 illustrates an example of a light emitting device ED in the display panel 110 according to the implementations of the present disclosure.

Each of the plurality of light emitting devices ED disposed in the display panel 110 according to the implementations of the present disclosure may be an inorganic-based light-emitting diode (LED). For example, each of the plurality of light emitting devices ED may be a micro light-emitting diode (micro LED). As an example, each of the plurality of light emitting devices ED may be a vertical light-emitting diode (see FIG. 4). As another example, each of the plurality of light emitting devices ED may be a flip-type light-emitting diode or a lateral-type light-emitting diode.

Each of the plurality of light emitting devices ED may include a first electrode E1, a first semiconductor layer 410 disposed on the first electrode E1, an active layer 415 disposed on the first semiconductor layer 410, a second semiconductor layer 420 disposed on the active layer 415, and a second electrode E2 disposed on the second semiconductor layer 420.

Each of the plurality of light emitting devices ED may further include a protection layer 430 covering the side surfaces of the first electrode E1, the first semiconductor layer 410, the active layer 415, the second semiconductor layer 420, and the second electrode E2.

For example, the first electrode E1 may be an anode electrode, and the second electrode E2 may be a cathode electrode. As another example, the first electrode E1 may be a cathode electrode and the second electrode E2 may be an anode electrode.

For example, the first electrode E1 may include at least one of gold (Au), copper (Cu), tin (Sn), titanium (Ti), aluminum (Al), and silver (Ag). For example, the second electrode E2 may be made of a transparent metal material (e.g., Transparent Conductive Material, TCO) such as ITO (Indium Tin Oxide) and IZO (Indium Zinc Oxide) capable of transmitting light.

The first semiconductor layer 410 may be disposed on the first electrode E1. For example, the first semiconductor layer 410 may be a p-type semiconductor and may include a semiconductor material having a chemical formula of AlxGayInl-x-yN (0≤x≤1, 0≤y≤1, 0≤x+y≤1), but is not limited thereto. For example, the semiconductor material included in the first semiconductor layer 410 may be at least one of p-type doped AlGaInN, GaN, AlGaN, InGaN, AIN, and InN, but is not limited thereto. The first semiconductor layer 410 may be doped with a p-type dopant, and the p-type dopant may be Mg, Zn, Ca, Se, or Ba, but is not limited thereto. For example, the first semiconductor layer 410 may be p-GaN doped with p-type Mg, but is not limited thereto.

Meanwhile, the light emitting device ED may further include an electron blocking layer disposed on the first semiconductor layer 410. The electron blocking layer may be a layer for suppressing or preventing too many electrons from flowing to the active layer 415. For example, the electron blocking layer may be p-AlGaN doped with p-type Mg, but is not limited thereto. The electron blocking layer may be omitted.

The active layer 415 may be disposed on the first semiconductor layer 410 or the electron blocking layer. The active layer 415 may emit light by the combination of electron-hole pairs according to an electric signal applied through the first semiconductor layer 410 and the second semiconductor layer 420. The active layer 415 may emit one of a first color light, a second color light, and a third color light. For example, the first color light may be red light, the second color light may be green light, and the third color light may be blue light.

The active layer 415 may include a material having a single or multiple quantum well structure. If the active layer 415 includes a material having a multiple quantum well structure, the active layer may have a structure in which a plurality of well layers and barrier layers are alternately laminated. In this case, the well layer may be formed of InGaN, and the barrier layer may be formed of GaN or AlGaN, but is not limited thereto.

Alternatively, the active layer 415 may have a structure in which semiconductor materials having a large band gap energy and semiconductor materials having a small band gap energy are alternately laminated, and may include different group III to group V semiconductor materials depending on the wavelength of the light emitted. For example, if indium is included among the semiconductor materials included in the active layer 415, the color of the light emitted may vary depending on the content of indium. For example, as the content of indium increases, light in a longer wavelength band may be emitted. For example, if the content of indium is about 15%, light in a blue wavelength band may be emitted, if the content of indium is about 25%, light in a green wavelength band may be emitted, and if the content of indium is about 35% or more, light in a red wavelength band may be emitted.

Meanwhile, the light emitting device ED may further include a superlattice layer disposed on the active layer 415. The superlattice layer may be a layer for relieving stress between the second semiconductor layer 420 and the active layer 415. For example, the superlattice layer may be formed of InGaN or GaN. The superlattice layer may be omitted.

The second semiconductor layer 420 may be disposed on the active layer 415 or the superlattice layer. For example, the second semiconductor layer 420 may be an n-type semiconductor, and may include a semiconductor material having a chemical formula of AlxGayInl-x-yN (0≤x≤1, 0≤y≤1, 0≤x+y≤1), but is not limited thereto. For example, the semiconductor material included in the second semiconductor layer 420 may be at least one of n-type doped AlGaInN, GaN, AlGaN, InGaN, AlN, and InN, but is not limited thereto. For example, the second semiconductor layer 420 may be doped with an n-type dopant, and the n-type dopant may be Si, Ge, or Sn, but is not limited thereto. For example, the second semiconductor layer 420 may be n-GaN doped with n-type Si, but is not limited thereto.

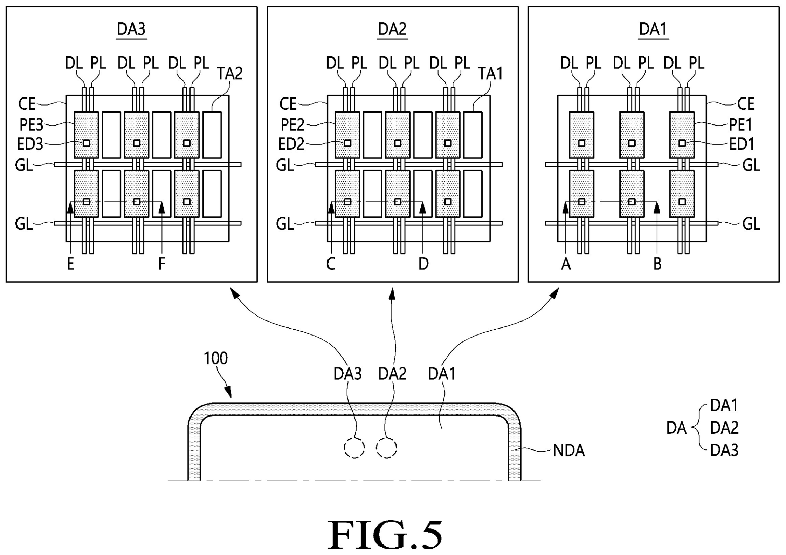

FIG. 5 illustrates an example of a planar structure of the first to third display areas DA1, DA2 and DA3 of the display panel 110 of the display device 100 according to implementations of the present disclosure. However, in the following description, FIGS. 1 to 4 are also referred to.

The display area DA of the display panel 110 according to the implementations of the present disclosure may include a first display area DA1, a second display area DA2, and a third display area DA3.

The first display area DA1 may be an outer area of the second display area DA2 and the third display area DA3. For example, the first display area DA1 may be disposed to surround the second display area DA2 and the third display area DA3. The first display area DA1 may also be referred to as a normal area, and each of the second display area DA2 and the third display area DA3 may also be referred to as an optical area.

The second display area DA2 may include a plurality of first transmission areas TA1. The first display area DA1 does not include a transmission area. For example, the second display area DA2 may have a smaller size than the first display area DA1.

The third display area DA3 may include a plurality of second transmission areas TA2. For example, the third display area DA3 may have a smaller size than the first display area DA1.

As an example, the third display area DA3 may have the same size as the second display area DA2. As another example, the third display area DA3 may have a smaller or larger size than the second display area DA2.

For example, the second transmission area TA2 may have a size smaller than or equal to the first transmission area TA1.

For example, the number of second transmission areas TA2 per unit area may be smaller than or equal to the number of first transmission areas TA1 per unit area.

The display panel 110 according to the implementations of the present disclosure may include a plurality of first light emitting devices ED1 positioned in the first display area DA1 and a plurality of second light emitting devices ED2 positioned in the second display area DA2.

The display panel 110 according to the implementations of the present disclosure may further include a plurality of first pixel electrodes PE1 electrically connected to a first electrodes E1 of each of the plurality of first light emitting devices ED1 and a plurality of second pixel electrodes PE2 electrically connected to a first electrodes E1 of each of the plurality of second light emitting devices ED2.

The display panel 110 according to the implementations of the present disclosure may further include a common electrode CE electrically connected in common to a second electrodes E2 of each of the plurality of first light emitting devices ED1 and a second electrodes E2 of each of the plurality of second light emitting devices ED2.

A plurality of first pixel electrodes PE1 may be arranged in a first display area DA1, and a plurality of second pixel electrodes PE2 may be arranged in a second display area DA2. A common electrode CE may be arranged in common in both the first display area DA1 and the second display area DA2.

The display panel 110 according to the implementations of the present disclosure may further include a plurality of first sub-pixel circuits SPC connected to a plurality of first light emitting devices ED1 and a plurality of second sub-pixel circuits SPC connected to a plurality of second light emitting devices ED2.

For example, the plurality of first sub-pixel circuits SPC may be arranged in the first display area DA1 and positioned below the plurality of first light emitting devices ED1.

For example, the plurality of second sub-pixel circuits SPC may be arranged in the second display area DA2 and positioned below the plurality of second light emitting devices ED2.

As another example, the plurality of second sub-pixel circuits SPC may be arranged in the first display area DA1, and a second pixel electrode PE2 may electrically connect the second sub-pixel circuit SPC arranged in the first display area DA1 and the second light emitting device ED2 arranged in the second display area DA2. In this case, the second pixel electrode PE2 may be arranged across the first display area DA1 and the second display area DA2.

The display panel 110 according to the implementations of the present disclosure may include signal lines for supplying various signals to the plurality of first light emitting devices ED1, the plurality of first sub-pixel circuits SPC, the plurality of second light emitting devices ED2, and the plurality of second sub-pixel circuits SPC. For example, the signal lines may include a data line DL for supplying a data voltage VDATA and a power line PL for supplying various powers. In addition, the signal lines may further include a gate line GL for supplying a gate signal.

Referring to FIG. 5, in the second display area DA2, each of the plurality of second light emitting devices ED2 may not overlap with the plurality of first transmission areas TA1, and may be disposed between the plurality of first transmission areas TA1.

The display panel 110 according to the implementations of the present disclosure may include a plurality of third light emitting devices ED3 positioned in the third display area DA3, and a plurality of third light emitting devices ED3 may be positioned in the third display area DA3, and may not overlap with the plurality of second transmission areas TA2. Each of the plurality of third light emitting devices ED3 may be disposed between the plurality of second transmission areas TA2.

The display panel 110 according to the implementations of the present disclosure may further include a plurality of third pixel electrodes PE3 electrically connected to the first electrodes E1 of each of the plurality of third light emitting devices ED3.

The common electrode CE commonly arranged in the first display area DA1 and the second display area DA2 may be disposed to extend in the third display area DA3. The common electrode CE may be commonly electrically connected to the second electrodes E2 of each of the plurality of third light emitting devices ED3.

The display panel 110 according to the implementations of the present disclosure may further include a plurality of third sub-pixel circuits SPC connected to the plurality of third light emitting devices ED3.

As an example, the plurality of third sub-pixel circuits SPC may be disposed in the third display area DA3, and may be located below the plurality of third light emitting devices ED3. As another example, a plurality of third sub-pixel circuits SPC may be disposed in the first display area DA1, and a third pixel electrode PE3 may electrically connect the third sub-pixel circuit SPC arranged in the first display area DA1 and the third light emitting device ED3 arranged in the third display area DA3. In this case, the third pixel electrode PE3 may be arranged across the first display area DA1 and the third display area DA3.

The display panel 110 according to the implementations of the present disclosure may include signal lines for supplying various signals to the plurality of third light emitting devices ED3 and the plurality of third sub-pixel circuits SPC. For example, the signal lines may include data lines DL for supplying data voltages VDATA and power lines PL for supplying various powers. In addition, the signal lines may further include gate lines GL for supplying gate signals.

Referring to FIG. 5, in the third display area DA3, each of the plurality of third light emitting devices ED3 may not overlap with the plurality of second transmission areas TA2, and may be arranged between the plurality of second transmission areas TA2.

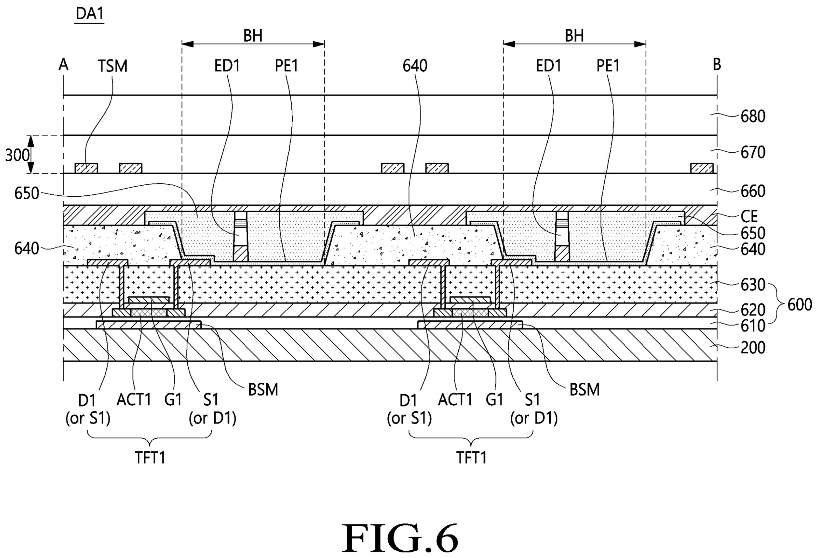

Hereinafter, it will be described a vertical structure of the first display area DA1, the second display area DA2, and the third display area DA3 included in the display area DA in more detail with reference to FIGS. 6 to 8.

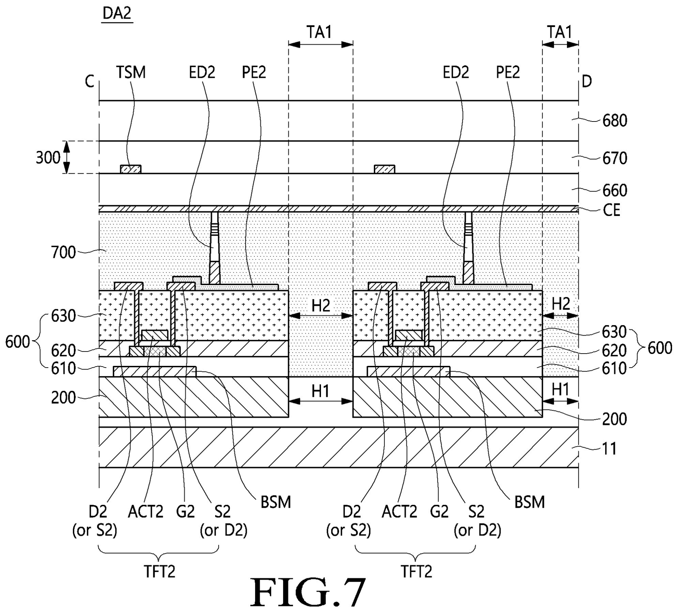

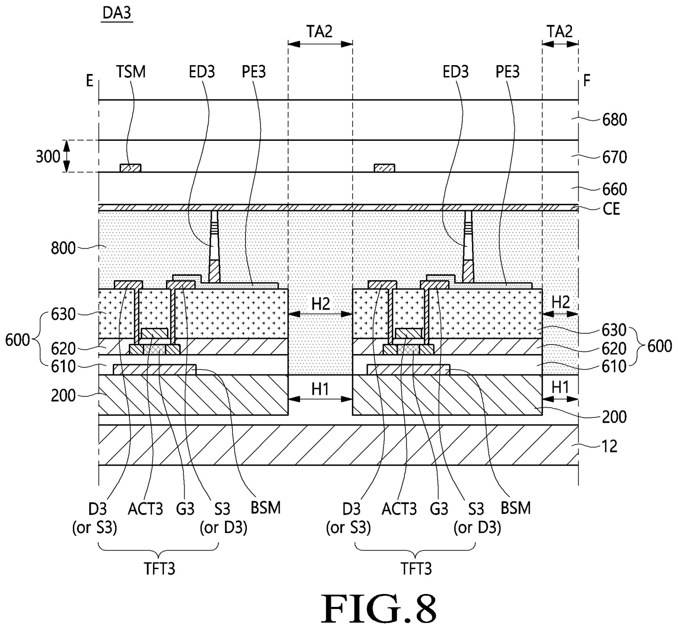

FIG. 6 is a cross-sectional view of an example of the first display area DA1 of the display panel 110 according to implementations of the present disclosure, FIG. 7 is a cross-sectional view of an example of the second display area DA2 of the display panel 110 according to implementations of the present disclosure, and FIG. 8 is a cross-sectional view of an example of the third display area DA3 of the display panel 110 according to implementations of the present disclosure. However, in the following description, FIGS. 1 to 5 are also referred to.

FIG. 6 is a cross-sectional view along line A-B of FIG. 5, FIG. 7 is a cross-sectional view along line C-D of FIG. 5, and FIG. 8 is a cross-sectional view along line E-F of FIG. 5.

Referring to FIGS. 6 and 7, the display panel 110 of the display device 100 according to the implementations of the present disclosure may include a first display area DA1, a second display area DA2 including a plurality of first transmission areas TA1 and having a smaller size than the first display area DA1, a first light emitting device ED1 positioned in the first display area DA1, and a second light emitting device ED2 positioned in the second display area DA2, not overlapping with the plurality of first transmission areas TA1, and disposed between the plurality of first transmission areas TA1.

Referring to FIGS. 6 and 7, the display panel 110 according to implementations of the present disclosure may include a first passivation layer 650 (in FIG. 6) disposed to surround a side of a first light emitting device ED1, and a second passivation layer 700 (in FIG. 7) disposed to surround a side of a second light emitting device ED2.

Referring to FIGS. 6 and 7, the display panel 110 according to implementations of the present disclosure may further include a substrate 200, a first transistor TFT1 disposed on the substrate 200 and positioned in a first display area DA1, a first pixel electrode PE1 electrically connecting a first source electrode S1 or a first drain electrode D1 of the first transistor TFT1 and a first electrode E1 of a first light emitting device ED1, a second transistor TFT2 disposed on the substrate 200 and positioned in a second display area DA2, a second pixel electrode PE2 electrically connecting a second source electrode S2 or a second drain electrode D2 of the second transistor TFT2 and the first electrode E1 of the second light emitting device ED2, and a common electrode CE disposed on the first light emitting device ED1, a first passivation layer 650, the second light emitting device ED2, and a second passivation layer 700.

The first light emitting device ED1 may be connected between the first pixel electrode PE1 and the common electrode CE. The second light emitting device ED2 may be connected between the second pixel electrode PE2 and the common electrode CE.

For example, each of the first light emitting device ED1 and the second light emitting device ED2 may be a vertical light-emitting diode.

For example, each of the first light emitting device ED1 and the second light emitting device ED2 may include a first electrode E1, a first semiconductor layer 410 disposed on the first electrode E1, an active layer 415 disposed on the first semiconductor layer 410, a second semiconductor layer 420 disposed on the active layer 415, and a second electrode E2 disposed on the second semiconductor layer 420 (see FIG. 4).

Referring to FIGS. 6 and 7, according to implementations of the present disclosure, the first pixel electrode PE1 disposed on the first display area DA1 may be a reflective electrode, and the second pixel electrode PE2 disposed on the second display area DA2 may be a transparent electrode.

Referring to FIGS. 6 and 7, according to implementations of the present disclosure, the common electrode CE commonly arranged in the first display area DA1 and the second display area DA2 may be a transparent electrode.

Referring to FIGS. 6 and 7, according to implementations of the present disclosure, the substrate 200 may have a plurality of first holes H1 overlapping with a plurality of first transmission areas TA1. That is, the plurality of first holes H1 formed in the substrate 200 may exist in the first display area DA1.

Accordingly, the transmittance of each of the plurality of first transmission areas TA1 may be increased, thereby improving the performance of the first electronic device 11 overlapping with the second display area DA2.

Referring to FIG. 6 and FIG. 7, the display panel 110 according to the implementations of the present disclosure may further include an insulating layer stack 600 disposed between the substrate 200 and a first passivation layer 650 and between the substrate 200 and a second passivation layer 700.

Referring to FIG. 7, according to the implementations of the present disclosure, the substrate 200 may have a plurality of first holes H1 overlapping with a plurality of first transmission areas TA1, or the insulating layer stack 600 may have a plurality of second holes H2 overlapping with a plurality of first transmission areas TA1.

Referring to FIG. 7, according to implementations of the present disclosure, the substrate 200 may have a plurality of first holes H1 overlapping with a plurality of first transmission areas TA1, and the insulating layer stack 600 may have a plurality of second holes H2 overlapping with a plurality of first transmission areas TA1.

Accordingly, the transmittance of each of the plurality of first transmission areas TA1 may be further increased, thereby further improving the performance of the first electronic device 11 overlapping with the second display area DA2.

Referring to FIG. 7, in some implementations, the second passivation layer 700 extends into the plurality of second holes H2 formed in the insulating layer stack 600, so as to be interposed between portions of the insulating layer stack 600. However, in some implementations, the second passivation layer 700 does not extend into the plurality of first holes H1 formed in the substrate 200.

Referring to FIGS. 6 and 7, the insulating layer stack 600 may include insulating layers for forming transistors TFT1 and TFT2 included in each sub-pixel circuit SPC.

Referring to FIGS. 6 and 7, the insulating layer stack 600 may include a buffer layer 610 disposed on the substrate 200, a gate insulating layer 620 disposed on the buffer layer 610, and an interlayer insulating layer 630 disposed on the gate insulating layer 620.

Referring to FIG. 6, the sub-pixel circuit SPC for driving the first light emitting device ED1 may include a first transistor TFT1. The first transistor TFT1 may include a first active layer ACT1, a first gate electrode G1, a first source electrode S1, and a first drain electrode D1.

The plurality of second holes H2 may be formed by penetrating through the buffer layer 610, the gate insulating layer 620, and the interlayer insulating layer 630.

If each sub-pixel SP has a structure as in FIG. 3, the first transistor TFT1 may be the driving transistor DT of FIG. 3.

The first transistor TFT1 may be disposed in the first display area DA1.

Referring to FIG. 7, the sub-pixel circuit SPC for driving the second light emitting device ED2 may include a second transistor TFT2. The second transistor TFT2 may include a second active layer ACT2, a second gate electrode G2, a second source electrode S2, and a second drain electrode D2.

If each sub-pixel SP has a structure as in FIG. 3, the second transistor TFT2 may be the driving transistor DT of FIG. 3.

As an example, as shown in FIG. 7, the second transistor TFT2 may be disposed in the second display area DA2.

As another example, the second transistor TFT2 may be disposed in the first display area DA1. In this case, the second pixel electrode PE2 may be disposed to extend across the first display area DA1 and the second display area DA2, and the second light emitting device ED2 in the second display area DA2 and the second transistor TFT2 in the first display area DA1 may be connected by the second pixel electrode PE2.

Referring to FIGS. 6 and 7, the first active layer ACT1 of the first transistor TFT1 and the second active layer ACT2 of the second transistor TFT2 may be disposed between the buffer layer 610 and the gate insulating layer 620. The first gate electrode G1 of the first transistor TFT1 and the second gate electrode G2 of the second transistor TFT2 may be disposed between the gate insulating layer 620 and the interlayer insulating layer 630. The first source electrode S1 and the first drain electrode D1 of the first transistor TFT1 and the second source electrode S2 and the second drain electrode D2 of the second transistor TFT2 may be disposed on the interlayer insulating layer 630.

Referring to FIG. 6, the first pixel electrode PE1 may be disposed on the interlayer insulating layer 630, and may extend over at least a portion of the first source electrode S1 or the first drain electrode D1 of the first transistor TFT1.

Referring to FIG. 7, the second pixel electrode PE2 may be disposed on the interlayer insulating layer 630, and may extend over at least a portion of the second source electrode S2 or the second drain electrode D2 of the second transistor TFT2.

Referring to FIG. 6, the display panel 110 according to the implementations of the present disclosure may further include a bank 640 for defining an emission area of the sub-pixels SP in the first display area DA1.

Referring to FIGS. 6 and 7, the bank 640 may be disposed in the first display area DA1. However, the bank 640 may not be disposed in the second display area DA2. Accordingly, the transmittance of the second display area DA2 may be improved.

Referring to FIG. 6, in the first display area DA1, the bank 640 may be disposed on the insulating layer stack 600. The bank 640 may have a bank hole BH that overlaps with a first portion of the first pixel electrode PE1. The first portion of the first pixel electrode PE1 may be disposed on the insulating layer stack 600, and may be a flat portion.

The first pixel electrode PE1 disposed in the first display area DA1 may be a reflective electrode.

In the first display area DA1, the first light emitting device ED1 may be disposed inside the bank hole BH. Both sides of the first portion of the first pixel electrode PE1 may extend along a side of the bank 640. That is, both sides of the first portion of the first pixel electrode PE1 may extend along the inner side of the bank hole BH. Accordingly, both sides of the first portion of the first pixel electrode PE1 configured as a reflective electrode may form an inclined surface (i.e., reflective surface).

Accordingly, light emitted from the first light emitting device ED1 may be reflected upward. As a result, a larger amount of light emitted from the first light emitting device ED1 may be emitted to the front of the display panel 110.

That is, the first light emitting device ED1 may be disposed inside the bank hole BH of the bank 640, the first pixel electrode PE1 may be configured as a reflective electrode, and a portion of the first pixel electrode PE1 may form an inclined surface, thereby improving the light extraction efficiency for the light emitted from the first light emitting device ED1.

Meanwhile, for example, the bank 640 may be configured as a black bank. Accordingly, the emission area of the sub-pixel SP may be defined more accurately.

Referring to FIG. 7, the common electrode CE may be disposed on the upper surface and the side surface of the first passivation layer 650. The common electrode CE may be disposed to cover the upper surface and the side surface of the first passivation layer 650. A rear surface of a portion of the common electrode CE may be in contact with the upper surface of the bank 640.

Referring to FIGS. 6 and 7, the first passivation layer 650 may be a diffusion layer or a sidewall diffusion layer, but the implementations of the present disclosure are not limited thereto.

The first passivation layer 650 may include an organic insulating material having fine particles dispersed therein, but is not limited thereto. For example, the first passivation layer 650 may be composed of siloxane having fine metal particles, such as titanium dioxide (TiO2) particles dispersed therein, but is not limited thereto. The light emitted from the first light emitting device ED1 may be scattered by the fine particles dispersed in the first passivation layer 650 and emitted to the outside of the display panel 110. Accordingly, the first passivation layer 650 may improve the extraction efficiency of the light emitted from the plurality of first light emitting devices ED1.

As an example, the second passivation layer 700 may include an organic insulating material in which fine particles are dispersed, but is not limited thereto. For example, the second passivation layer 700 may be composed of siloxane in which fine metal particles, such as titanium dioxide (TiO2) particles, are dispersed, but is not limited thereto. The light emitted from the second light emitting device ED2 may be scattered by the fine particles dispersed in the second passivation layer 700 and emitted to the outside of the display panel 110. Accordingly, the second passivation layer 700 may improve the extraction efficiency of light emitted from the plurality of second light emitting devices ED2.

As another example, in order for light transmission to occur normally from the front to the back of the display panel 110 in the plurality of first transmission areas TA1, the characteristics of the second passivation layer 700 may be different depending on the location. The second passivation layer 700 may include a portion that overlaps with the first transmission area TA1 and a portion that does not overlap with the first transmission area TA1. The portion of the second passivation layer 700 that overlaps with the first transmission area TA1 and the portion of the second passivation layer 700 that does not overlap with the first transmission area TA1 may have different characteristics. For example, a portion of the second passivation layer 700 that overlaps with the first transmission area TA1 may include an organic insulating material from which fine particles (e.g., fine metal particles) have been removed so that the light straight-line transmission characteristics are greater than the light scattering characteristics, and a portion of the second passivation layer 700 that does not overlap with the first transmission area TA1 may include an organic insulating material including fine particles (e.g., fine metal particles) so that the light scattering characteristics are relatively greater. A portion of the second passivation layer 700 that does not overlap with the first transmission area TA1 may be a portion that overlaps with an emission area of the second light emitting device ED2.

In addition, the second passivation layer 700 may include an organic material. For example, the second passivation layer 700 may include polyimide, but is not limited thereto.

The first passivation layer 650 may include an organic material. For example, the first passivation layer 650 may include, but is not limited to, polyimide.

Referring to FIG. 8, the display area DA of the display panel 110 according to implementations of the present disclosure may further include a third display area DA3, a third light emitting device ED3, and a third passivation layer 800.

The third display area DA3 may include a plurality of second transmission areas TA2, and may have a smaller size than the first display area DA1.

The third light emitting device ED3 may be located in the third display area DA3, may not overlap with the plurality of second transmission areas TA2, and may be disposed between the plurality of second transmission areas TA2.

The third passivation layer 800 may be disposed to surround the side of the third light emitting device ED3.

Referring to FIG. 8, the display panel 110 according to the implementations of the present disclosure may further include a third transistor TFT3 disposed on a substrate 200 and located in a third display area DA3, a third pixel electrode PE3 electrically connecting a third source electrode S3 or a third drain electrode D3 of the third transistor TFT3 and a first electrode E1 of a third light emitting device ED3, and a common electrode CE disposed on the third light emitting device ED3 and a third passivation layer 800.

The third light emitting device ED3 may be connected between the third pixel electrode PE3 and the common electrode CE.

For example, the third light emitting device ED3 may be a vertical light-emitting diode.

For example, each of the third light emitting devices ED3 may include a first electrode E1, a first semiconductor layer 410 disposed on the first electrode E1, an active layer 415 disposed on the first semiconductor layer 410, a second semiconductor layer 420 disposed on the active layer 415, and a second electrode E2 disposed on the second semiconductor layer 420 (see FIG. 4).

Referring to FIG. 8, according to implementations of the present disclosure, the third pixel electrode PE3 disposed on the third display area DA3 may be a transparent electrode.

Referring to FIG. 8, the common electrode CE may be commonly disposed on the first display area DA1, the second display area DA2, and the third display area DA3, and may be a transparent electrode.

Referring to FIG. 8, according to implementations of the present disclosure, the substrate 200 may have a plurality of first holes H1 overlapping with a plurality of second transmission areas TA2. That is, the plurality of first holes H1 formed in the substrate 200 may be provided not only in the second display area DA2 but also in the third display area DA3.

Accordingly, the transmittance of each of the plurality of second transmission areas TA2 may be increased, thereby improving the performance of the second electronic device 12 overlapping with the third display area DA3.

Referring to FIG. 8, the display panel 110 according to implementations of the present disclosure may further include an insulating layer stack 600 disposed between the substrate 200 and the third passivation layer 800.

Referring to FIG. 8, according to implementations of the present disclosure, the substrate 200 may have a plurality of first holes H1 overlapping with a plurality of second transmission areas TA2, or the insulating layer stack 600 may have a plurality of second holes H2 overlapping with a plurality of second transmission areas TA2.

Referring to FIG. 8, according to implementations of the present disclosure, the substrate 200 may have a plurality of first holes H1 overlapping with a plurality of second transmission areas TA2, and the insulating layer stack 600 may have a plurality of second holes H2 overlapping with a plurality of second transmission areas TA2.

Accordingly, the transmittance of each of the plurality of second transmission areas TA2 may be further increased, thereby further improving the performance of the second electronic device 12 overlapping with the third display area DA3.

Referring to FIG. 8, in some implementations, the third passivation layer 800 extends into the plurality of second holes H2 formed in the insulating layer stack 600, so as to be interposed between different portions of the insulating layer stack 600. However, in some implementations. the third passivation layer 800 does not extend into the plurality of first holes H1 formed in the substrate 200. The third passivation layer 800 may be a separate layer from the second passivation layer 700, or may be a layer connected to the second passivation layer 700.

Referring to FIG. 8, the insulating layer stack 600 may include insulating layers for forming transistors TFT3 included in each sub-pixel circuit SPC.

Referring to FIG. 8, the insulating layer stack 600 may include a buffer layer 610 disposed on the substrate 200, a gate insulating layer 620 disposed on the buffer layer 610, and an interlayer insulating layer 630 disposed on the gate insulating layer 620.

Referring to FIG. 8, the sub-pixel circuit SPC for driving the third light emitting device ED3 may include a third transistor TFT3. The third transistor TFT3 may include a third active layer ACT3, a third gate electrode G3, a third source electrode S3, and a third drain electrode D3.

If each sub-pixel SP has a structure as in FIG. 3, the third transistor TFT3 may be a driving transistor DT of FIG. 3.

For example, as shown in FIG. 8, the third transistor TFT3 may be disposed in the third display area DA3.

As another example, the third transistor TFT3 may be disposed in the first display area DA1. In this case, the third pixel electrode PE3 may be extended to the first display area DA1 and the third display area DA3, and the third light emitting device ED3 disposed in the third display area DA3 and the third transistor TFT3 disposed in the first display area DA1 may be connected by the third pixel electrode PE3.

Referring to FIG. 8, the third active layer ACT3 of the third transistor TFT3 may be disposed between the buffer layer 610 and the gate insulating layer 620. The third gate electrode G3 of the third transistor TFT3 may be disposed between the gate insulating layer 620 and the interlayer insulating layer 630. The third source electrode S3 and the third drain electrode D3 of the third transistor TFT3 may be disposed on the interlayer insulating layer 630.

Referring to FIG. 8, the third pixel electrode PE3 may be disposed on the interlayer insulating layer 630, and may extend over at least a portion of the third source electrode S3 or the third drain electrode D3 of the third transistor TFT3.

Referring to FIG. 8, the bank 640 may not be disposed in the third display area DA3. Accordingly, the transmittance of the third display area DA3 may be improved.

Referring to FIG. 8, as an example, the third passivation layer 800 may include an organic insulating material having fine particles dispersed therein, but is not limited thereto. For example, the third passivation layer 800 may be composed of siloxane having fine metal particles, such as titanium dioxide (TiO2) particles dispersed therein, but is not limited thereto. Light emitted from the third light emitting device ED3 may be scattered by the fine particles dispersed in the third passivation layer 800 and may be emitted to the outside of the display panel 110. Accordingly, the third passivation layer 800 may improve the extraction efficiency of light emitted from a plurality of third light emitting devices ED3.

As another example, in order to normally transmit light from the front to the back of the display panel 110 in a plurality of second transmission areas TA2, the characteristics of the third passivation layer 800 may be different depending on the location. The third passivation layer 800 may include a portion that overlaps with the second transmission area TA2 and a portion that does not overlap with the second transmission area TA2. The portion of the third passivation layer 800 that overlaps with the second transmission area TA2 and the portion of the third passivation layer 800 that does not overlap with the second transmission area TA2 may have different characteristics. For example, a portion of the third passivation layer 800 that overlaps with the second transmission area TA2 may include an organic insulating material from which fine particles (e.g., fine metal particles) have been removed so that the light straight-line transmission characteristics are enhanced rather than the light scattering characteristics, and a portion of the third passivation layer 800 that does not overlap with the second transmission area TA2 may include an organic insulating material including fine particles (e.g., fine metal particles) so as to enhance the light scattering characteristics. A portion of the third passivation layer 800 that does not overlap with the second transmission area TA2 may be a portion that overlaps with an emission area of the third light emitting device ED3.

In addition, the third passivation layer 800 may include an organic material. For example, the third passivation layer 800 may include polyimide, but is not limited thereto.

Referring to FIGS. 6 to 8, the display device 100 according to the implementations of the present disclosure may further include an overcoat layer 660 disposed on a common electrode CE, a touch sensor layer 300 disposed on the overcoat layer 660, and a cover layer 680 disposed on the touch sensor layer 300.

The touch sensor layer 300 may include a plurality of touch sensor metals TSM disposed on the overcoat layer 660, and a touch protection layer 670 disposed on the plurality of touch sensor metals TSM.

The plurality of touch sensor metals TSM may not overlap with the first light emitting device ED1 and the second light emitting device ED2. In the first display area DA1, the plurality of touch sensor metals TSM may overlap with the bank 640.

The overcoat layer 660 may include a transparent insulating material.

Due to the insulating properties of the overcoat layer 660, a short-circuit between the touch sensor metals TSM can be prevented, and a short-circuit between the common electrode CE and the touch sensor metals TSM can be prevented.

In addition, due to the transparent properties of the overcoat layer 660, light emitted from the first to third light emitting devices ED1, ED2 and ED3 may be transmitted through the overcoat layer 660.

Referring to FIG. 7, the first electronic device 11 may be configured to overlap with the second display area DA2, receive first light that passes through a plurality of first transmission areas TA1, and perform a first operation using the first light.

Referring to FIG. 8, the second electronic device 12 may be configured to overlap with the third display area DA3, receive second light that passes through a plurality of second transmission areas TA2, and perform a second operation using the second light.

The second light used by the second electronic device 12 for the second operation may have a different wavelength from the first light used by the first electronic device 11 for the first operation. For example, the wavelength of the first light may be a visible light wavelength, and the wavelength of the second light may be an infrared wavelength.

The display device 100 according to the implementations of the present disclosure described above may include a substrate 200 in which a first display area DA1 and a second display area DA2 including a plurality of first transmission areas TA1 are partitioned, a first light emitting device ED1 positioned in the first display area DA1, and a second light emitting device ED2 positioned in the second display area DA2, not overlapping with the plurality of first transmission areas TA1, and positioned between the plurality of first transmission areas TA1.

The display device 100 according to the implementations of the present disclosure may include an insulating layer stack 600 positioned between the substrate 200 and the first light emitting device ED1 and between the substrate 200 and the second light emitting device ED2.

The substrate 200 may have a plurality of first holes H1 overlapping with a plurality of first transmission areas TA1. The insulating layer stack 600 may have a plurality of second holes H2 overlapping with a plurality of first transmission areas TA1.

The display device 100 according to the implementations of the present disclosure may include a first passivation layer 650 disposed on an insulating layer stack 600 and surrounding a side surface of a first light emitting device ED1, and a second passivation layer 700 disposed on an insulating layer stack 600 and surrounding a side surface of a second light emitting device ED2. In some implementations, the second passivation layer 700 extends into a plurality of second holes H2, but does not extend into a plurality of first holes H1.

The display device 100 according to the implementations of the present disclosure may further include a bank 640 disposed on an insulating layer stack 600. The bank 640 may be disposed in a first display area DA1, and may not be disposed in a second display area DA2.

Referring to FIGS. 6 to 8, the display panel 110 according to the implementations of the present disclosure may further include a lower shield metal BSM disposed below each of the first to third transistors TFT1, TFT2 and TFT3.

The lower shield metal BSM may overlap with the first to third active layers ACT1, ACT2 and ACT3 of the first to third transistors TFT1, TFT2 and TFT3.

The lower shield metal BSM may be disposed between the substrate 200 and the buffer layer 610.

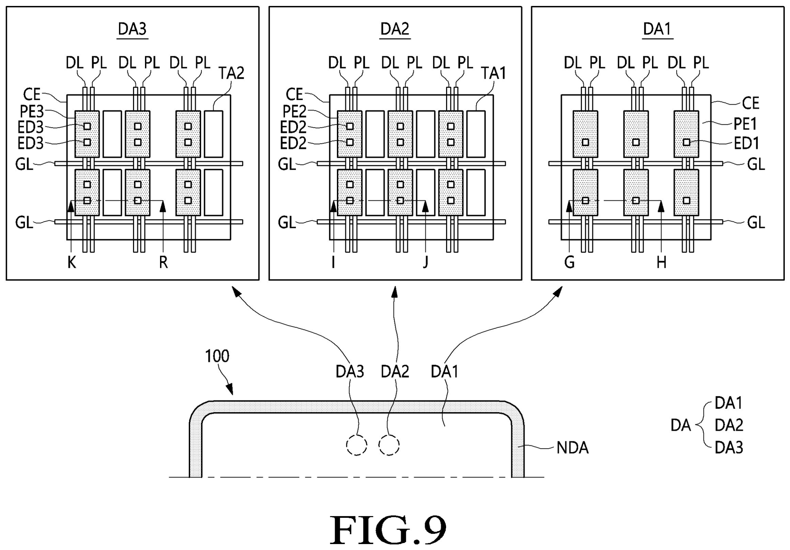

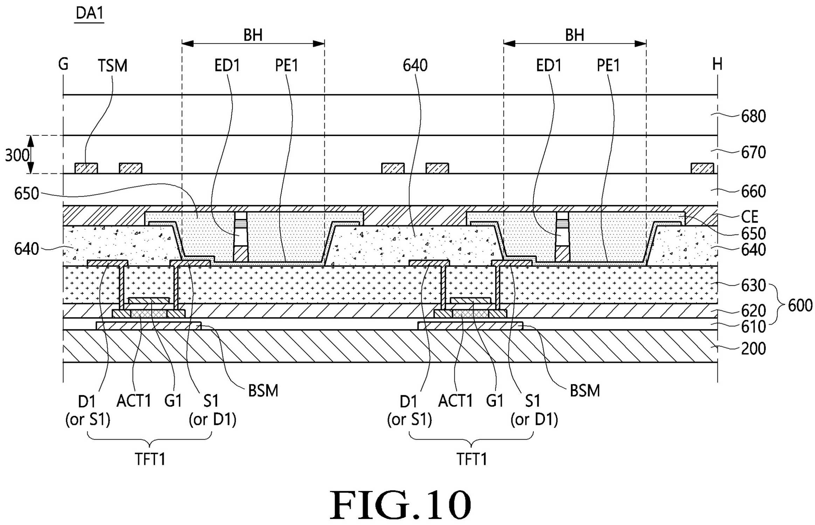

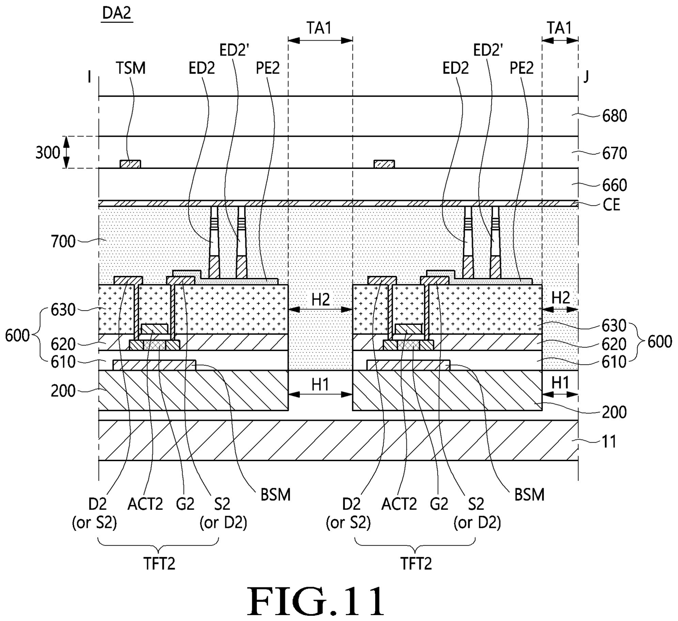

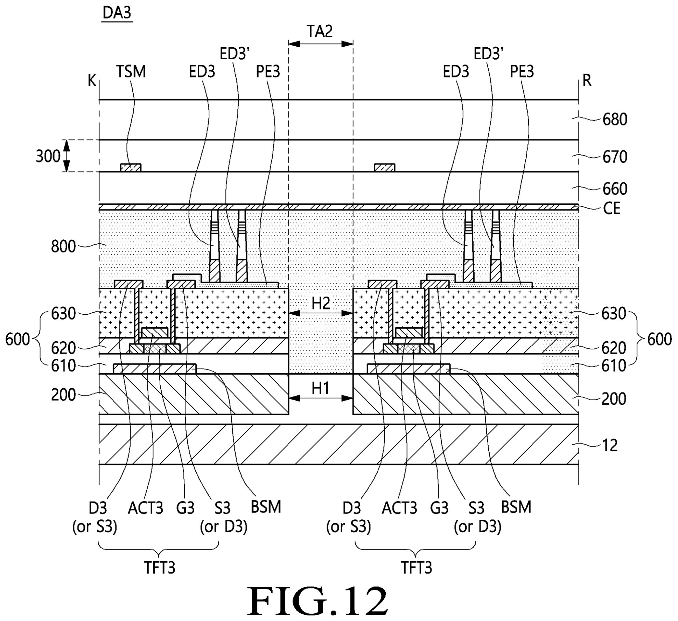

FIG. 9 illustrates a planar structure of the first to third display areas DA1, DA2 and DA3 of the display panel 110 according to the implementations of the present disclosure. FIG. 10 is a cross-sectional view of the first display area DA1 of the display panel 110 according to the implementations of the present disclosure. FIG. 11 is a cross-sectional view of a second display area DA2 of a display panel 110 according to implementations of the present disclosure. FIG. 12 is a cross-sectional view of a third display area DA3 of a display panel 110 according to implementations of the present disclosure.

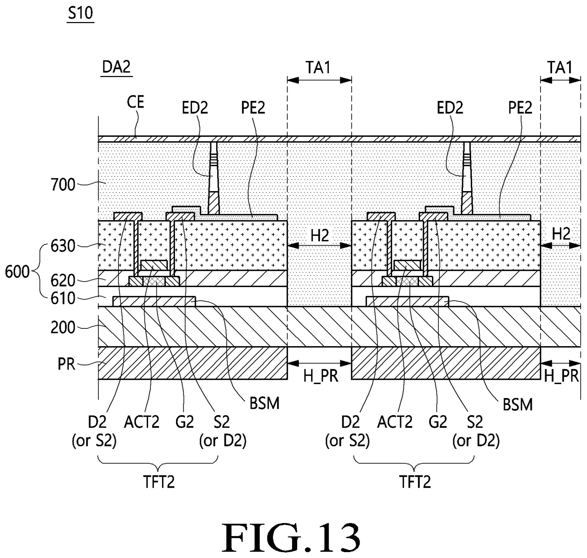

FIG. 10 is a cross-sectional view along the line G-H of FIG. 9, FIG. 11 is a cross-sectional view along the line I-J of FIG. 9, and FIG. 13 is a cross-sectional view along the line K-R of FIG. 9.

The plan view of FIG. 9 may correspond to the plan view of FIG. 5, the cross-sectional view of FIG. 10 may correspond to the cross-sectional view of FIG. 6, the cross-sectional view of FIG. 11 may correspond to the cross-sectional view of FIG. 7, and the cross-sectional view of FIG. 12 may correspond to the cross-sectional view of FIG. 8. Therefore, in explaining with reference to FIGS. 9 to 12, differences from FIGS. 5 to 8 will be mainly explained, and explanations of the same content may be omitted.

Referring to FIGS. 9 and 10, in the first display area DA1, one first light emitting device ED1 may be disposed in one sub-pixel SP. That is, in the first display area DA1, one first light emitting device ED1 may be connected between one first pixel electrode PE1 and a common electrode CE.

However, referring to FIGS. 9 and 11, in the second display area DA2, two or more second light emitting devices ED2 and ED2' may be disposed in one sub-pixel SP. That is, in the second display area DA2, two or more second light emitting devices ED2 and ED2' may be connected between one second pixel electrode PE2 and the common electrode CE.

That is, the display panel 110 according to the implementations of the present disclosure may further include at least one second light emitting device ED2' as at least one first additional light emitting device connected between the second pixel electrode PE2 and the common electrode CE. The second light emitting device ED2 and at least one second light emitting device ED2' as at least one first additional light emitting device may be connected in parallel between the second pixel electrode PE2 and the common electrode CE. Accordingly, it is possible to prevent luminance unevenness between the first display area DA1 and the second display area DA2.

Referring to FIG. 9 and FIG. 12, in the third display area DA3, two or more third light emitting devices ED3 and ED3' may be disposed in one sub-pixel SP. That is, in the third display area DA3, two or more third light emitting devices ED3 and ED3' may be connected between one third pixel electrode PE3 and the common electrode CE.

That is, the display panel 110 according to the implementations of the present disclosure may further include at least one third light emitting device ED3' as at least one second additional light emitting device connected between the third pixel electrode PE3 and the common electrode CE. The third light emitting device ED3 and at least one third light emitting device ED3' as at least one second additional light emitting device may be connected in parallel between the third pixel electrode PE3 and the common electrode CE. Accordingly, it is possible to prevent luminance non-uniformity between the first display area DA1 and the third display area DA3.

Referring to FIGS. 9, 11, and 12, the number of first transmission areas TA1 per unit area in the second display area DA2 may be greater than or equal to the number of second transmission areas TA2 per unit area in the third display area DA3.

Referring to FIGS. 9, 11, and 12, the number of first light emitting devices ED1 per unit area in the second display area DA2 may be greater than or equal to the number of second light emitting devices ED2 per unit area in the third display area DA3. That is, the resolution of the second display area DA2 may be greater than or equal to the resolution of the third display area DA3.

FIGS. 13 to 15 illustrate manufacturing processes (S10, S20 and S30) for the second display area DA2 of the display panel 110 according to implementations of the present disclosure.

Referring to FIG. 13, in a photoresist forming step (S10), the substrate 200, the insulating layer stack 600, the second transistors TFT2, the second pixel electrodes PE2, the second light emitting devices ED2, the second passivation layer 700, and the common electrode CE may be formed. Here, the second passivation layer 700 may include an organic insulating material such as polyimide.

In the photoresist forming step (S10), the insulating layer stack 600 may be in a state in which second holes H2 are formed, and the substrate 200 may be in a state in which first holes H1 are not formed. In some implementations, the second passivation layer 700 extends into the second holes H2 of the insulating layer stack 600, so as to be interposed between portions of the insulating layer stack 600.

In the photoresist forming step (S10), a photoresist PR may be placed on the back surface of the substrate 200. The photoresist PR may include a hole H_PR corresponding to the second holes H2 of the insulating layer stack 600. That is, the hole H_PR of the photoresist PR may overlap with the second holes H2 of the insulating layer stack 600.

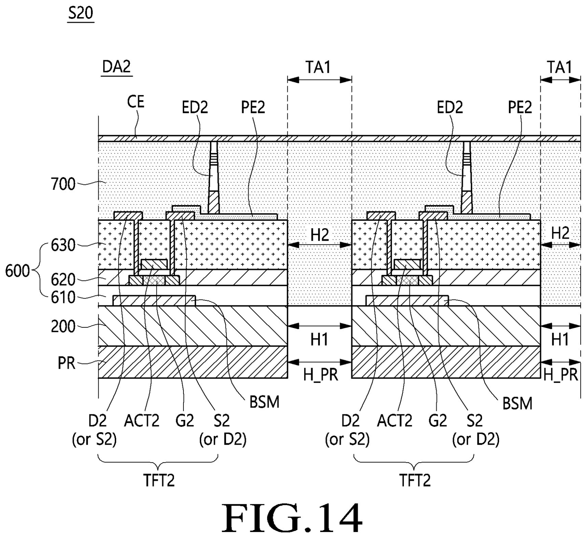

Referring to FIG. 14, in a substrate etching step (S20) performed after the photoresist forming step (S10), an area corresponding to the hole H_PR of the photoresist PR in the substrate 200 may be etched using a substrate etchant. Accordingly, a first hole H1 may be formed in the substrate 200.

The second passivation layer 700 may include an organic insulating material such as polyimide. Therefore, the second passivation layer 700 may not react to the substrate etchant.

Therefore, in some implementations. during etching of the area corresponding to the hole H_PR of the photoresist PR in the substrate 200, the second passivation layer 700 that extends into the second holes H2 of the insulating layer stack 600 may not be etched. In such scenarios, the second passivation layer 700 may act as an etching stopper.

As described above, in some implementations. even though the substrate etching step (S20) is performed, the second passivation layer 700 may be maintained in a state of extending into the second holes H2 of the insulating layer stack 600 and being interposed between portions of the insulating layer stack 600, thereby improving the structural stability of the display panel 110.

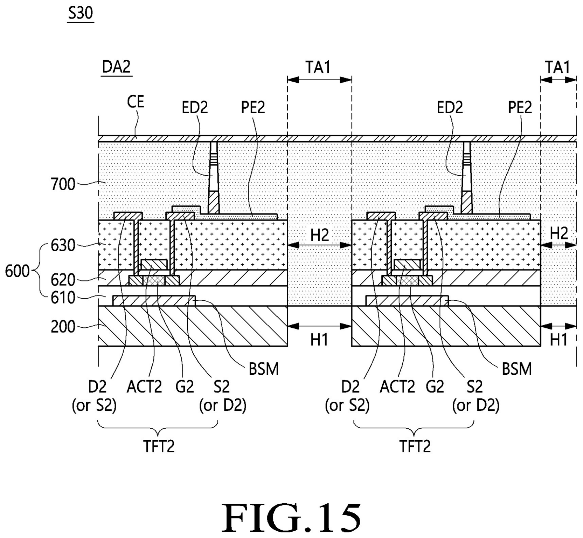

Referring to FIG. 15, after the substrate etching step (S20), a photoresist removal step (S30) may be performed, so that the photoresist PR formed on the back surface of the substrate 200 for substrate etching may be removed.

A display device according to implementations of the present disclosure may be briefly described as follows.

A display device according to implementations of the present disclosure may include a first display area, a second display area including a plurality of first transmission areas and having a size smaller than the first display area, a first light emitting device located in the first display area, a second light emitting device located in the second display area and disposed between the plurality of first transmission areas, a first passivation layer disposed to surround a side surface of the first light emitting device, and a second passivation layer disposed to surround a side surface of the second light emitting device.

Each of the first light emitting device and the second light emitting device may include a first electrode, a first semiconductor layer disposed on the first electrode, an active layer disposed on the first semiconductor layer, a second semiconductor layer disposed on the active layer, and a second electrode disposed on the second semiconductor layer.

The display device according to implementations of the present disclosure may further include a substrate. a first transistor disposed on the substrate and located in the first display area, a first pixel electrode electrically connecting a first source electrode or a first drain electrode of the first transistor and a first electrode of the first light emitting device, a second transistor disposed on the substrate and located in the second display area, a second pixel electrode electrically connecting a second source electrode or a second drain electrode of the second transistor and a first electrode of the second light emitting device, and a common electrode disposed on the first light emitting device, the first passivation layer, the second light emitting device, and the second passivation layer.

The first light emitting device may be connected between the first pixel electrode and the common electrode.

The second light emitting device may be connected between the second pixel electrode and the common electrode.

The first pixel electrode may be a reflective electrode, and the second pixel electrode may be a transparent electrode.

The common electrode may be a transparent electrode.

The substrate may have a plurality of first holes overlapping with the plurality of first transmission areas.

The display device according to implementations of the present disclosure may further include an insulating layer stack disposed between the substrate and the first passivation layer, and between the substrate and the second passivation layer.

The substrate may have a plurality of first holes overlapping with the plurality of first transmission areas, or the insulating layer stack may have a plurality of second holes overlapping with the plurality of first transmission areas.

The substrate may have the plurality of first holes overlapping with the plurality of first transmission areas, and the insulating layer stack may have the plurality of second holes overlapping with the plurality of first transmission areas. In some implementations, the second passivation layer extends into the plurality of second holes, but does not extend into the plurality of first holes.

The insulating layer stack may include a buffer layer disposed on the substrate, a gate insulating layer disposed on the buffer layer, and an interlayer insulating layer disposed on the gate insulating layer.

A first active layer of the first transistor and a second active layer of the second transistor may be disposed between the buffer layer and the gate insulating layer.

A first gate electrode of the first transistor and a second gate electrode of the second transistor may be disposed between the gate insulating layer and the interlayer insulating layer.

The first source electrode and the first drain electrode of the first transistor and the second source electrode and the second drain electrode of the second transistor may be disposed on the interlayer insulating layer.

The first pixel electrode may be disposed on the interlayer insulating layer, and may extend over at least a portion of the first source electrode or the first drain electrode of the first transistor,

The second pixel electrode may be disposed on the interlayer insulating layer, and may extend over at least a portion of the second source electrode or the second drain electrode of the second transistor.

The display device according to implementations of the present disclosure may further include a bank disposed on the insulating layer stack. The bank may have a bank hole overlapping with a first portion of the first pixel electrode.

The first light emitting device may be disposed inside the bank hole.

Both sides of the first portion of the first pixel electrode may extend along an inner side surface of the bank hole.

The bank may be disposed in the first display area, and may be not disposed in the second display area. The bank may be a black bank.

The display device according to implementations of the present disclosure may further include at least one additional light emitting device connected between the second pixel electrode and the common electrode.

The display device according to implementations of the present disclosure may further include an overcoat layer disposed on the common electrode, a touch sensor layer disposed on the overcoat layer, and a cover layer disposed on the touch sensor layer.

The overcoat layer may include a transparent insulating material.

The touch sensor layer may include a plurality of touch sensor metals disposed on the overcoat layer, and a touch protection layer disposed on the plurality of touch sensor metals.

The plurality of touch sensor metals may not overlap with the first light emitting device and the second light emitting device.

The second passivation layer may include an organic material.

The display device according to implementations of the present disclosure may further include a third display area including a plurality of second transmission areas, a third light emitting device located in the third display area, not overlapping with the plurality of second transmission areas, and disposed between the plurality of second transmission areas, and a third passivation layer disposed to surround a side surface of the third light emitting device.

The display device according to implementations of the present disclosure may further include a first electronic device overlapping with the second display area, and configured to receive first light passing through the plurality of first transmission areas and perform a first operation using the first light.

The display device according to implementations of the present disclosure may further include a second electronic device overlapping with the third display area, and configured to receive second light passing through the plurality of second transmission areas and perform a second operation using the second light.

The second light has a different wavelength than the first light.

A display device according to implementations of the present disclosure may include a substrate including a first display area and a second display area, the second display area including a plurality of first transmission areas, a first light emitting device located in the first display area, a second light emitting device located in the second display area and disposed between the plurality of first transmission areas, and an insulating layer stack disposed between the substrate and the first light emitting device, and between the substrate and the second light emitting device.

The substrate may have a plurality of first holes overlapping with the plurality of first transmission area. The insulating layer stack may have a plurality of second holes overlapping with the plurality of first transmission areas.

The display device according to implementations of the present disclosure may further include a first passivation layer disposed on the insulating layer stack and surrounding a side surface of the first light emitting device, and a second passivation layer disposed on the insulating layer stack and surrounding a side surface of the second light emitting device.

The second passivation layer may extend into the plurality of second holes, but may not extend into the plurality of first holes.

The display device according to implementations of the present disclosure may further include a bank disposed on the insulating layer stack, disposed in the first display area, and not disposed in the second display area.

The display device according to implementations of the present disclosure may further include at least one additional light emitting device connected in parallel with the second light emitting device, but may not include at least one additional light emitting device connected in parallel with the first light emitting device.

The following numbered examples describe further implementations of the present disclosure:

Example 1: A display device comprising: a first display area; a second display area including a plurality of first transmission areas configured to transmit external light through the second display area; a first light emitting device located in the first display area; a second light emitting device located in the second display area and disposed, in a plan view, between the plurality of first transmission areas; a first passivation layer disposed to cover a side surface of the first light emitting device; and a second passivation layer disposed to cover a side surface of the second light emitting device.

Example 2: The display device of Example 1, wherein each of the first light emitting device and the second light emitting device includes: a first electrode; a first semiconductor layer disposed on the first electrode; an active layer disposed on the first semiconductor layer; a second semiconductor layer disposed on the active layer; and a second electrode disposed on the second semiconductor layer.

Example 3: The display device of Example 1 or 2, further comprising: a substrate; a first transistor disposed on the substrate and located in the first display area; a first pixel electrode electrically connecting a first source electrode or a first drain electrode of the first transistor and a first electrode of the first light emitting device; a second transistor disposed on the substrate and located in the second display area; a second pixel electrode electrically connecting a second source electrode or a second drain electrode of the second transistor and a first electrode of the second light emitting device; and a common electrode disposed on the first light emitting device, the first passivation layer, the second light emitting device, and the second passivation layer, wherein the first light emitting device is connected between the first pixel electrode and the common electrode, and the second light emitting device is connected between the second pixel electrode and the common electrode.

Example 4: The display device of Example 3, wherein the first pixel electrode is a reflective electrode, wherein the second pixel electrode is a transparent electrode, wherein the common electrode is a transparent electrode.

Example 5: The display device of Example 3 or 4, wherein the substrate has a plurality of first holes overlapping with the plurality of first transmission areas.

Example 6: The display device of any of Examples 3 to 5, further comprising an insulating layer stack disposed, in a cross-sectional view, between the substrate and the first passivation layer, and between the substrate and the second passivation layer, wherein the substrate has a plurality of first holes overlapping with the plurality of first transmission areas, and/or the insulating layer stack has a plurality of second holes overlapping with the plurality of first transmission areas.

Example 7: The display device of Example 6, wherein the substrate has the plurality of first holes overlapping with the plurality of first transmission areas, and the insulating layer stack has the plurality of second holes overlapping with the plurality of first transmission areas, wherein the second passivation layer extends into the plurality of second holes so as to be interposed within the insulating layer stack, and wherein the second passivation layer does not extend into the plurality of first holes.

Example 8: The display device of Example 6 or 7, wherein the insulating layer stack includes: a buffer layer disposed on the substrate; a gate insulating layer disposed on the buffer layer; and an interlayer insulating layer disposed on the gate insulating layer, wherein a first active layer of the first transistor and a second active layer of the second transistor are disposed, in a cross-sectional view, between the buffer layer and the gate insulating layer, wherein a first gate electrode of the first transistor and a second gate electrode of the second transistor are disposed, in the cross-sectional view, between the gate insulating layer and the interlayer insulating layer, wherein the first source electrode and the first drain electrode of the first transistor and the second source electrode and the second drain electrode of the second transistor are disposed on the interlayer insulating layer, wherein the first pixel electrode is disposed on the interlayer insulating layer and extends over at least a portion of the first source electrode or the first drain electrode of the first transistor, wherein the second pixel electrode is disposed on the interlayer insulating layer and extends over at least a portion of the second source electrode or the second drain electrode of the second transistor, wherein the buffer layer, the gate insulating layer, and the interlayer insulating layer are all penetrated to form the plurality of second holes.

Example 9: The display device of any of Examples 6 to 8, further comprising a bank disposed on the insulating layer stack, wherein the bank has a bank hole overlapping with a first portion of the first pixel electrode, wherein the first light emitting device is disposed inside the bank hole, wherein both sides of the first portion of the first pixel electrode extend along an inner side surface of the bank hole.

Example 10: The display device of Example 9, wherein the bank is disposed in the first display area, and is not disposed in the second display area.

Example 11: The display device of any of Examples 3 to 10, further comprising at least one additional light emitting device connected between the second pixel electrode and the common electrode.

Example 12: The display device of any of Examples 3 to 11, further comprising: an overcoat layer disposed on the common electrode; a touch sensor layer disposed on the overcoat layer; and a cover layer disposed on the touch sensor layer, wherein the overcoat layer includes a transparent insulating material.

Example 13: The display device of Example 12, wherein the touch sensor layer includes: a plurality of touch sensor metals disposed on the overcoat layer; and a touch protection layer disposed on the plurality of touch sensor metals, wherein the plurality of touch sensor metals do not overlap with the first light emitting device and the second light emitting device.

Example 14: The display device of any of Examples 1 to 13, wherein the second passivation layer includes an organic material.

Example 15: The display device of any of Examples 1 to 14, further comprising: a third display area including a plurality of second transmission areas; a third light emitting device located in the third display area, not overlapping with the plurality of second transmission areas, and disposed between the plurality of second transmission areas in the plan view; and a third passivation layer disposed to surround a side surface of the third light emitting device.

Example 16: The display device of Example 15, further comprising: a first electronic device overlapping with the second display area, and configured to receive first light passing through the plurality of first transmission areas and perform a first operation using the first light; and a second electronic device overlapping with the third display area, and configured to receive second light passing through the plurality of second transmission areas and perform a second operation using the second light, wherein the second light has a different wavelength than the first light.

Example 17: A display device comprising: a substrate including a first display area and a second display area, the second display area including a plurality of first transmission areas; a first light emitting device located in the first display area; a second light emitting device located in the second display area and disposed, in a plan view, between the plurality of first transmission areas; and an insulating layer stack disposed, in a cross-sectional view, between the substrate and the first light emitting device, and between the substrate and the second light emitting device, wherein the substrate has a plurality of first holes overlapping with the plurality of first transmission areas, and the insulating layer stack has a plurality of second holes overlapping with the plurality of first transmission areas.

Example 18: The display device of Example 17, further comprising: a first passivation layer disposed on the insulating layer stack and surrounding a side surface of the first light emitting device; and a second passivation layer disposed on the insulating layer stack and surrounding a side surface of the second light emitting device, wherein the second passivation layer exetnds into the plurality of second holes to be interposed between portions of the insulating layer stack, and does not extend into the plurality of first holes.

Example 19: The display device of Example 17 or 18, further comprising a bank disposed on the insulating layer stack, disposed in the first display area, and not disposed in the second display area

Example 20: The display device of any of Examples 17 to 19, further comprising at least one additional light emitting device connected in parallel with the second light emitting device.

According to the implementations of the present disclosure described above, it is possible to provide a display device having a light transmission structure which allows an electronic device located below a display panel to normally receive light without exposing the electronic device receiving light to the front.

According to the implementations of the present disclosure, it is possible to provide a display device having a light transmission structure suitable for inorganic-based light emitting devices.

According to the implementations of the present disclosure, it is possible to provide a display device having a light transmission structure capable of increasing the transmittance of a transmission area.

According to the implementations of the present disclosure, it is possible to provide a display device capable of improving the luminance in a display area including a light transmission area.

According to the implementations of the present disclosure, it is possible to provide a display device capable of achieving high brightness even with low power by using inorganic-based light emitting device.

## Claims

1. A display device comprising:
a first display area (DA1);
a second display area (DA2) including a plurality of first transmission areas (TA1) configured to transmit external light through the second display area (DA2);
a first light emitting device (ED1) located in the first display area (DA1);
a second light emitting device (ED2) located in the second display area (DA2) and disposed, in a plan view, between the plurality of first transmission areas (TA1);
a first passivation layer (650) disposed to cover a side surface of the first light emitting device (ED1); and
a second passivation layer (700) disposed to cover a side surface of the second light emitting device (ED2).

2. The display device of claim 1, wherein each of the first light emitting device (ED1) and the second light emitting device (ED2) includes:
a first electrode (E1);
a first semiconductor layer (410) disposed on the first electrode (E1);
an active layer (415) disposed on the first semiconductor layer (410);
a second semiconductor layer (420) disposed on the active layer (415); and
a second electrode (E2) disposed on the second semiconductor layer (420).

3. The display device of claim 1 or 2, further comprising:
a substrate (200);
a first transistor (TFT1) disposed on the substrate (200) and located in the first display area (DA1);
a first pixel electrode (PE1) electrically connecting a first source electrode (S1) or a first drain electrode (D1) of the first transistor (TFT1) and a first electrode (E1) of the first light emitting device (ED1);
a second transistor (TFT2) disposed on the substrate (200) and located in the second display area (DA2);
a second pixel electrode (PE2) electrically connecting a second source electrode (S2) or a second drain electrode (D2) of the second transistor (TFT2) and a first electrode (E1) of the second light emitting device (ED2); and
a common electrode (CE) disposed on the first light emitting device (ED1), the first passivation layer (650), the second light emitting device (ED2), and the second passivation layer (700),
wherein the first light emitting device (ED1) is connected between the first pixel electrode (PE1) and the common electrode (CE), and the second light emitting device (ED2) is connected between the second pixel electrode (PE2) and the common electrode (CE).

4. The display device of claim 3, wherein the first pixel electrode (PE1) is a reflective electrode,
wherein the second pixel electrode (PE2) is a transparent electrode, and
wherein the common electrode (CE) is a transparent electrode.

5. The display device of claim 3 or 4, wherein the substrate (200) has a plurality of first holes (H1) overlapping with the plurality of first transmission areas (TA1).

6. The display device of any of claims 3 to 5, further comprising an insulating layer stack (600) disposed, in a cross-sectional view, between the substrate (200) and the first passivation layer (650), and between the substrate (200) and the second passivation layer (700),
wherein the substrate (200) has a plurality of first holes (H1) overlapping with the plurality of first transmission areas (TA1), and/or the insulating layer stack (600) has a plurality of second holes (H2) overlapping with the plurality of first transmission areas (TA1).

7. The display device of claim 6, wherein the substrate (200) has the plurality of first holes (H1) overlapping with the plurality of first transmission areas (TA1), and the insulating layer stack (600) has the plurality of second holes (H2) overlapping with the plurality of first transmission areas (TA1),
wherein the second passivation layer (700) extends into the plurality of second holes (H2) so as to be interposed within the insulating layer stack (600), and
wherein the second passivation layer (700) does not extend into the plurality of first holes (H1).

8. The display device of claim 6 or 7, wherein the insulating layer stack (600) includes:
a buffer layer (610) disposed on the substrate (200);
a gate insulating layer (620) disposed on the buffer layer (610); and
an interlayer insulating layer (630) disposed on the gate insulating layer (620),
wherein a first active layer (ACT1) of the first transistor (TFT1) and a second active layer (ACT2) of the second transistor (TFT2) are disposed, in a cross-sectional view, between the buffer layer (610) and the gate insulating layer (620),
wherein a first gate electrode (G1) of the first transistor (TFT1) and a second gate electrode (G2) of the second transistor (TFT2) are disposed, in the cross-sectional view, between the gate insulating layer (620) and the interlayer insulating layer (630),
wherein the first source electrode (S1) and the first drain electrode (D1) of the first transistor (TFT1) and the second source electrode (S2) and the second drain electrode (D2) of the second transistor are disposed on the interlayer insulating layer (630),
wherein the first pixel electrode (PE1) is disposed on the interlayer insulating layer (630) and extends over at least a portion of the first source electrode (S1) or the first drain electrode (D1) of the first transistor (TFT1),
wherein the second pixel electrode (PE2) is disposed on the interlayer insulating layer (630) and extends over at least a portion of the second source electrode (S2) or the second drain electrode (D2) of the second transistor (TFT2),
wherein the buffer layer (610), the gate insulating layer (620), and the interlayer insulating layer (630) are all penetrated to form the plurality of second holes (H2).

9. The display device of any of claims 6 to 8, further comprising a bank (640) disposed on the insulating layer stack (600),
wherein the bank (640) has a bank hole (BH) overlapping with a first portion of the first pixel electrode (PE1),
wherein the first light emitting device (ED1) is disposed inside the bank hole (BH),
wherein both sides of the first portion of the first pixel electrode (PE1) extend along an inner side surface of the bank hole (BH).

10. The display device of claim 9, wherein the bank (640) is disposed in the first display area (DA1), and is not disposed in the second display area (DA2).

11. The display device of any of claims 3 to 10, further comprising at least one additional light emitting device (ED2') connected between the second pixel electrode (PE2) and the common electrode (CE).

12. The display device of any of claims 3 to 11, further comprising:
an overcoat layer (660) disposed on the common electrode (CE);
a touch sensor layer (300) disposed on the overcoat layer (660); and
a cover layer (680) disposed on the touch sensor layer (300),
wherein the overcoat layer (660) includes a transparent insulating material.

13. The display device of claim 12, wherein the touch sensor layer (300) includes:
a plurality of touch sensor metals (TSM) disposed on the overcoat layer (660); and
a touch protection layer (670) disposed on the plurality of touch sensor metals (TSM),
wherein the plurality of touch sensor metals (TSM) do not overlap with the first light emitting device (ED1) and the second light emitting device (ED2).

14. The display device of any of claims 1 to 13, wherein the second passivation layer (700) includes an organic material.

15. The display device of any of claims 1 to 14, further comprising:
a third display area (DA3) including a plurality of second transmission areas (TA2);
a third light emitting device (ED3) located in the third display area (DA3), not overlapping with the plurality of second transmission areas (TA2), and disposed between the plurality of second transmission areas (TA2) in the plan view; and
a third passivation layer (800) disposed to surround a side surface of the third light emitting device (ED3),
the display device, preferably, further comprising:
a first electronic device (11) overlapping with the second display area (DA2), and configured to receive first light passing through the plurality of first transmission areas (TA1) and perform a first operation using the first light; and
a second electronic device (12) overlapping with the third display area (DA3), and configured to receive second light passing through the plurality of second transmission areas (TA2) and perform a second operation using the second light,
wherein the second light has a different wavelength than the first light.
